# EUROPÄISCHE PATENTSCHRIFT

(11) **EP 2 275 790 B1**
(45) Veröffentlichungstag und Bekanntmachung des Hinweises auf die Patenterteilung: **09.05.2012**
(21) Anmeldenummer: 10187587.0
(22) Anmeldetag: 02.03.2009
(51) Int. Cl.: G01J 4/04, G02B 5/30

(54) **Integrierter Polarisationssensor**
Integrated polarization sensor
Capteur de polarisation intégré

(30) Priorität: 14.03.2008 DE 102008014334
(43) Veröffentlichungstag der Anmeldung: 19.01.2011
(62) Teilanmeldung aus: 09718713.2
(73) Patentinhaber: Fraunhofer-Gesellschaft zur Förderung der Angewandten Forschung e.V., 80686 München (DE)
(72) Erfinder: Junger, Stephan, 91088 Bubenreuth (DE); Weber, Norbert, 91367 Weissenohe (DE); Tschekanlinkskij, Wladimir, 90429 Nürnberg (DE)
(74) Vertreter: Schenk, Markus

(56) Entgegenhaltungen:
- DE-A1- 3 931 540
- THARP J S ET AL: "Design and Demonstration of an Infrared Meanderline Phase Retarder", IEEE TRANSACTIONS ON ANTENNAS AND PROPAGATION, IEEE SERVICE CENTER, PISCATAWAY, NJ, US, Bd. 55, Nr. 11, 1. November 2007 (2007-11-01), Seiten 2983-2988, XP011196924, ISSN: 0018-926X

## Beschreibung

Die vorliegende Erfindung bezieht sich auf ein integriertes Bauelement, das beispielsweise als Polarisationssensor eingesetzt werden kann.

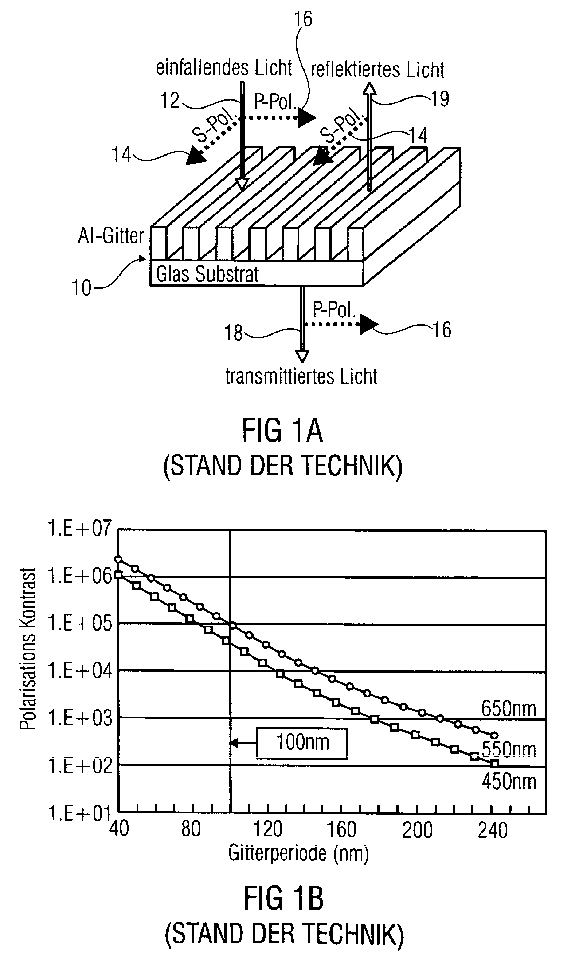

Ein Einsatz von Gitterstrukturen als Polarisationsfilter ist seit langem bekannt. Drahtgitter-Polarisatoren (Wire Grid Polarizers, WGP) wurden zunächst im Mikrowellenbereich, später aber auch im Bereich des infraroten und sichtbaren Lichts verwendet. Die für sichtbares Licht erforderlichen Strukturbreiten sind extrem klein. In der Veröffentlichung von Seh-Won Ahn et al., "Fabrication of a 50 nm half-pitch wire grid polarizer using nanoimprint lithography", Nanotechnology 16 (2005), 1874-1877, wird eine Struktur beschrieben, deren Gitterstegbreite sowie Zwischenräume zwischen den Gitterstegen nur 50 nm betragen, woraus eine Gitterperiode (grating pitch) von 100 nm resultiert. Eine derartige Gitterstruktur 10 ist schematisch in Fig. 1a gezeigt.

Einfallendes Licht 12 mit zwei zueinander senkrecht stehenden Polarisationsrichtungen 14, 16 fällt auf die Gitterstruktur 10, die angepasst ist, um Licht mit einer der beiden Polarisationsrichtungen (P-Polarisation) durchzulassen und Licht mit der anderen Polarisationsrichtung (S-Polarisation) zu reflektieren. In dem in Fig. 1a gezeigten Beispiel ist die Gitterstruktur 10 angepasst, um p-polarisiertes Licht 16 durchzulassen, so dass auf einer von dem einfallenden Licht 12 abgewandten Seite der Gitterstruktur 10 durchgelassenes, p-polarisiertes Licht 18 wahrgenommen werden kann. Die Durchlass-Polarisationsrichtung 16 ist senkrecht zu den Gitterlinien. S-polarisiertes Licht 14, bei dem die Polarisation parallel zu den Gitterlinien verläuft, wird von der Gitterstruktur 10 reflektiert.

Ein Polarisationskontrast, d.h. das Verhältnis der Transmission für S- und P-polarisiertes Licht (TE- und TM-Polarisation), ist abhängig von der Gitterperiode. Dieser Zusammenhang ist schematisch in Fig. 1b dargestellt. Es lässt sich erkennen, dass der Polarisationskontrast für Licht einer vordefinierten Wellenlänge mit zunehmender Gitterperiode abnimmt.

Eine weitere Alternative, Polarisationsfilter herzustellen, besteht darin, zusätzliche optische, typischerweise organische, Schichten als Polarisationsfilter zu nutzen, was aber bedeutet, dass zusätzlich zu einer Halbleiterprozessierung weitere Prozessschritte erforderlich sind. Eine derartige Vorgehensweise ist beispielsweise in der Veröffentlichung "Fabrication of PVA Micropolarizer Arrays for a CMOS Image Sensor", NSF Summer Undergraduate Fellowship in Sensor Technologies, Nathan Lazarus (Electrical Engineering), University of Pennsylvania, beschrieben.

Zusätzliche optische Schichten zur Verbesserung des Polarisationskontrasts erfordern einen höheren Herstellungsaufwand und sind in vielen Fällen bezüglich des zulässigen Temperaturbereichs beschränkt. Sollen mehrere einzelne Polarisationssensoren als Pixel für einen bildgebenden polarisationsempfindlichen Sensor kombiniert werden, beispielsweise mit alternierender Empfindlichkeit für horizontal und vertikal polarisiertes Licht, ist auch ein erheblicher Aufwand u.a. zur Justage erforderlich.

Die Schrift US 7186968 A1 beschreibt einen integrierten Drahtgitter-Polarisator mit einer linienförmig strukturierten Metallschicht. Innerhalb der strukturierten Metallschicht wird ein Liniengitter mit einer Gitterperiode von 320 nm hergestellt. Unter dieser strukturierten Metallschicht befindet sich eine dielektrische Schicht, unter der wiederum eine Photodiode platziert ist. Es handelt sich um ein integriertes Bauelement, das neben der polarisationsempfindlichen strukturierten Metallschicht auch einen lichtempfindlichen Empfänger, beispielsweise eine CMOS-Photodiode, aufweist. Es wird beschrieben, dass ein guter Polarisationseffekt nur dann erreicht wird, wenn die Gitterperiode weniger als ein Zehntel der Wellenlänge der zu filternden elektromagnetischen Strahlung bzw. des zu filternden Lichts ist. Als optimale Gitterperiode für sichtbares Licht wird 31,5 nm genannt. Es wird beschrieben, dass auch größere Perioden einen guten Polarisationseffekt bewirken, wobei sich aber "größer" auf einen Faktor 2 gegenüber der optimalen Gitterperiode bezieht. Die in der US-Offenlegungsschrift beschriebene Struktur mit einer Gitterperiode von über 300 nm führt jedoch gegenüber dem Optimalwert zu einer erheblichen Verschlechterung des Polarisationskontrasts (vgl. Fig. 1b).

Kleine Gitterperioden, wie beispielsweise Gitterperioden von 100 nm oder kleiner, sind derzeit mit verfügbaren Halbleiterprozessen wie z.B. CMOS-Prozessen kaum herstellbar. Wird jedoch eine gröbere Gitterperiode verwendet, sinkt der Polarisationskontrast stark ab, wie es anhand von Fig. 1b bereits beschrieben wurde. Wird beispielsweise in einem 0,13 µm-CMOS-Prozess ein Polarisationsgitter mit einer dort kleinsten Periode von etwa 400 nm hergestellt, so sinkt der Polarisationskontrast für sichtbares Licht drastisch. Für viele Anwendungen wird aber ein hoher Polarisationskontrast (polarization extinction ratio) benötigt.

Ein Ansatz, Polarisatoren mit gutem Polarisationskontrast zu realisieren, stellt eine Verwendung photonischer Kristalle dar (siehe z.B. Virginie Lousse et al., "Angular and polarization properties of a photonic crystal slab mirror", 19. April 2004, Vol. 12, NO. 8/OPTICS EXPRESS 1575). Unter einem photonischen Kristall soll im Nachfolgenden eine dreidimensionale periodische Struktur verstanden werden, deren periodisch angeordnete metallische und/oder dielektrische Strukturelemente Abmessungen und Abstände zueinander aufweisen, die in der Größenordnung einer Wellenlänge einer zu filternden elektromagnetischen Strahlung, insbesondere Licht, liegen. Photonische Kristalle können strukturierte Metalle, Halbleiter, Gläser oder Polymere umfassen und zwingen elektromagnetische Strahlung, insbesondere Licht, mittels ihrer spezifischen Struktur dazu, in der sich für eine Bauteilfunktion notwendigen Art und Weise im Medium auszubreiten. Sie können eine Ausbreitung elektromagnetischer Strahlung in ähnlicher Weise beeinflussen, wie das periodische Potential in Halbleiterkristallen die Ausbreitung von Elektronen. Dies führt dazu, dass sich elektromagnetische Strahlung bzw. Licht bestimmter Wellenlängen nicht im photonischen Kristall ausbreiten kann. Diese Wellenlängen sind gewissermaßen verboten. Die spektrale Filterwirkung photonischer Kristalle ist seit einigen Jahren bekannt und durch Experimente bestätigt.

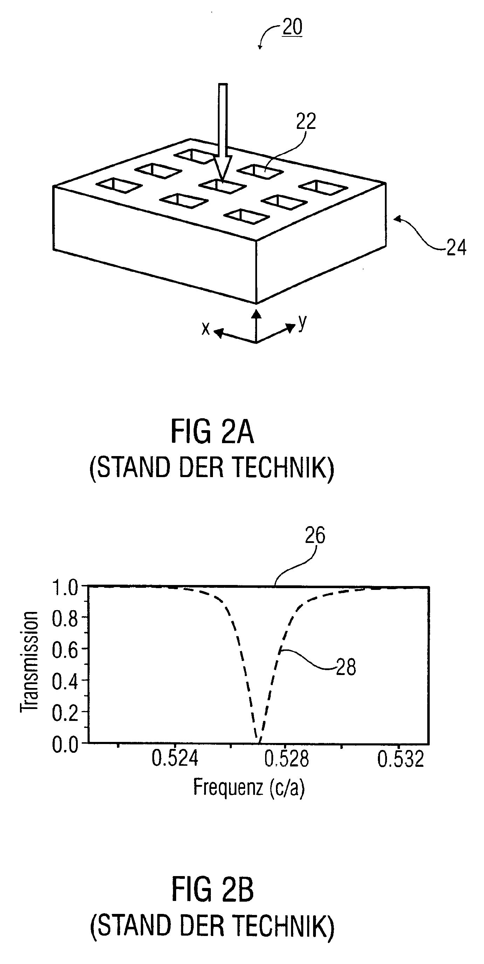

Während photonische Kristalle, die aus zweidimensionalen Arrays von z.B. rotationssymmetrischen Löchern mit gleicher Periode in x- und y-Richtung (Lichtausbreitung in z-Richtung) bestehen, keine Polarisationsabhängigkeit aufweisen, kann durch Aufheben der Invarianz der zweidimensionalen Anordnung der Strukturelemente, aus denen ein photonischer Kristall aufgebaut ist, oder durch Aufheben der Invarianz der Strukturelemente selbst gegenüber Drehungen um die z-Richtung um 90° bzw. 270° - im folgenden auch kurz als "90°-Drehinvarianz" bezeichnet - eine anisotrope spektrale Transmission erreicht werden. Werden beispielsweise Löcher bzw. Spalte verwendet, die in x- und y-Richtung unterschiedliche Ausdehnungen haben, ergibt sich ein photonischer Kristall, der je nach Polarisation des einfallenden Lichts unterschiedlich reflektiert. Bei geeigneter Auslegung kann ein extrem hoher Reflektionsgrad erzielt werden, was zu einem sehr guten Polarisationskontrast führen kann. Dies ist z.B. darauf zurückzuführen, dass eine photonische Bandlücke für nur eine der beiden Polarisationsrichtungen generiert wird und aufgrund derer dann für verbotene Wellenlängen eine fast perfekte Reflektion erfolgt. Fig. 2a zeigt schematisch einen solchen photonischen Kristall, Fig. 2b die zugehörigen Simulationsergebnisse.

Der in Fig. 2a gezeigte photonische Kristall 20 ist als rein dielektrischer photonischer Kristall ausgeführt. Luftspalte 22 sind in einem Siliziumsubstrat 24 angeordnet, das bei verwendeten Wellenlängen von > 1000 nm transparent ist.

Fig. 2b zeigt ein simuliertes Transmissions-Spektrum für die in Fig. 2a dargestellte Struktur.

In x-Richtung polarisiertes Licht (Kurve 26) wird dabei für verschiedene Wellenlängen nahezu zu 100% transmittiert, wo hingegen in y-Richtung polarisiertes Licht (Kurve 28) in einer Lorentzschen Linienform reflektiert wird.

Der Herstellungsaufwand für rein dielektrische photonische Kristalle, wie sie beispielhaft in Fig. 2a gezeigt sind, ist relativ groß. Durch eine Verwendung eines massiven Trägermaterials, z.B. Silizium, können derartige Strukturen schlecht für sichtbares Licht verwendet werden. Ferner handelt es sich um eine rein passive Struktur, die noch extern angebrachte Sensoren zur Detektion des transmittierten Lichts benötigt.

Angesichts der Nachteile des Stands der Technik besteht die Aufgabe der vorliegenden Erfindung darin, ein verbessertes Konzept für Polarisationssensoren zur Detektion zirkular polarisierter elektromagnetischer Strahlung, insbesondere integrierte Polarisationssensoren, bereit zu stellen.

Diese Aufgabe wird durch einen integrierten Polarisationssensor gemäß Patentanspruch 1 , ein Verfahren gemäß Patentanspruch 8 gelöst.

Eine Erkenntnis der vorliegenden Erfindung besteht darin, dass ein polarisationskontraststarker Polarisationssensor als integriertes Bauteil bereit gestellt werden kann, indem ein opto-elektronisches Bauteil, wie z.B. eine Photodiode, zusammen mit einer Mehrzahl von darüber angeordneten strukturierten Metallschichten gemeinsam mit dem opto-elektronischen Bauteil auf einem Halbleitersubstrat in einem Halbleiterherstellungsprozess, wie z.B. einem CMOS-Prozess, angeordnet wird. Durch das Anordnen von wenigstens zwei übereinander liegenden, strukturierten Metallschichten kann, überraschenderweise, der resultierende Polarisationskontrast gegenüber nur einer strukturierten Metallschicht, bei gleich bleibenden Strukturperioden, deutlich gesteigert werden.

Gemäß Ausführungsbeispielen der vorliegenden Erfindung umfasst ein integrierter Polarisationssensor ein opto-elektronisches Sensorelement und eine Polarisationsfilterstruktur mit wenigstens zwei vertikal übereinander liegenden, strukturierten Metallschichten, wobei die Polarisationsstruktur ausgebildet ist, um elektromagnetische Strahlung mit einer vorbestimmten Polarisation zu dem opto-elektronischen Sensorelement zu transmittieren, wobei das opto-elektronische Sensorelement und die Polarisationsstruktur gemeinsam auf ein Halbleitersubstrat integriert sind.

Gemäß Ausführungsbeispielen der vorliegenden Erfindung wird zusätzlich zu einem opto-elektronischen Bauteil auf einem Halbleitersubstrat wenigstens ein photonischer Kristall bzw. eine periodische Anordnung von photonischen Kristallen aus einem Schichtstapel aus strukturierten metallischen dielektrischen Schichten integriert, mit optisch filternden Eigenschaften. Die strukturierten Metallschichten weisen dazu Struktur- bzw. Nanoelemente auf, deren Abmessungen und Abstände zueinander kleiner als die Wellenlängen einfallenden Lichts sind, für das der integrierte Polarisationssensor ausgebildet ist. Die Nanoelemente der Metallschichten können dreidimensional periodisch angeordnet sein. Gemäß Ausführungsbeispielen können benachbarte Nanoelemente benachbarter Metallschichten identisch ausgebildet sein und auf einer gemeinsamen optischen Achse liegen. Nanoelemente können gemäß Ausführungsbeispielen Nanoöffnungen mit Abmessungen und Abständen in dem vorbestimmten Lichtwellenlängenbereich sein. Gemäß einer Ausführungsform umfassen die Nanoelemente nicht-90°-drehinvariante Öffnungen mit Abmessungen und Abständen in dem vorbestimmten Wellenlängenbereich. Die wenigstens zwei vertikal übereinander liegenden, strukturierten Metallschichten können jeweils auch einfache Gitterlinienstrukturen aufweisen.

Bei einem als Polarisationssensor wirkenden integrierten Bauelement gemäß Ausführungsbeispielen wird eine auf einer dem opto-elektronischen Sensor bzw. der Photodiode abgewandten Seite der Polarisationsfilterstruktur einfallende elektromagnetische Strahlung durch die Polarisationsfilterstruktur gefiltert, so dass in einer Nähe des opto-elektronischen Sensors nur noch elektromagnetische Strahlung der vorbestimmten Polarisation empfangbar ist.

Weitere vorteilhafte Weiterbildungen sind Gegenstand der Unteransprüche.

Mit Ausführungsbeispielen der vorliegenden Erfindung ist es möglich, einen Polarisationssensor aufzubauen, der keine zusätzlichen optischen Filterschichten benötigt, sondern in dem als polarisationsselektives Element geeignete Subwellenlängenstrukturen innerhalb vorhandener Metallschichten eines Halbleiterprozesses ausgebildet werden. Dabei werden vorzugsweise diese Metallschichten strukturiert, um die gewünschte optische Funktionalität zu erreichen.

Durch eine Verwendung von zwei oder mehr vertikal übereinander liegenden, strukturierten Metallschichten statt nur einer, lässt sich ein verbesserter Polarisationskontrast erzielen, ohne das in CMOS-Technologie nicht herstellbar feine Strukturen notwendig wären.

Durch die Verwendung von zwei oder mehr Metallschichten statt nur einer, sind dreidimensionale, polarisationsselektive Strukturen möglich, die über einfache Liniengitter hinausgehen, wie z.B. durch die strukturierten Metallschichten definierte photonische Kristalle. Dadurch kann ebenfalls ein höherer Kontrast erzielt werden, obwohl die Strukturen relativ grob sind. Kommerzielle CMOS-Technologien mit 0,13 µm oder 0,18 µm Gatelänge sind dafür ausreichend, unter Umständen eventuell auch bereits 0,35 µm CMOS-Technologien.

Durch unterschiedliche Metallstrukturen in mehreren Ebenen kann beispielsweise auch elliptisch polarisiertes Licht und nicht nur linear polarisiertes Licht erkennbar bzw. unterscheidbar gemacht werden. Eine Lösung mit konventionellen optischen Polarisationsfiltern würde einen Aufbau mit optischen Verzögerungsplatten, sogenannte λ/4-Plättchen, erfordern.

Eine weitere Erkenntnis der vorliegenden ßeschreibung besteht darin, dass ein integrierter Polarisationssensor mit einem Polarisationssensorelement, das einen opto-elektronischen Sensor und eine Polarisationsfilterstruktur mit wenigstens einer strukturierten Metallschicht aufweist, und bei dem die wenigstens eine strukturierte Metallschicht ansprechend auf elektromagnetische Strahlung mit einer vorbestimmten Polarisation eine höhere Transmission durch die Polarisationsfilterstruktur zu dem opto-elektronischen Sensor (31) ergibt als für von der vorbestimmten Polarisation abweichende Polarisationen, und bei dem der opto-elektronische Sensor und die Polarisationsfilterstruktur gemeinsam auf einem Halbleitersubstrat integriert sind, auch anders als in Form einer Gitterstruktur gebildet werden kann, nämlich indem die wenigstens eine strukturierte Metallschicht entweder eine erste laterale Verteilung von ersten Öffnungen mit einer größten lateralen Ausdehnung in einer ersten Richtung und eine zweite laterale Verteilung von zweiten, von den ersten Öffnungen beabstandeten Öffnungen mit einer größten lateralen Ausdehnung in einer zweiten, zu der ersten unterschiedlichen Richtung aufweist, oder eine laterale Verteilung von nicht-konvexen Öffnungen mit einer lateralen Ausdehnung aufweist, die in zwei zueinander unterschiedlichen lateralen Richtungen unterschiedlich groß ist, aufweist. Dabei kann die laterale Verteilung ein regelmäßiges Array mit unterschiedlichen Wiederholabständen in der ersten und zweiten Richtung bzw. in den zueinander unterschiedlichen Richtungen sein, wobei der Wiederholabstand in der Richtung größerer lateraler Ausdehnung größer sein kann.

Bevorzugte Ausführungsbeispiele der vorliegenden Erfindung werden nachfolgend Bezug nehmend auf die beiliegenden Zeichnungen näher erläutert. Es zeigen:
- Fig. 1a: eine schematische Darstellung eines Drahtgitter- polarisators;
- Fig. 1b: eine Abhängigkeit von Polarisationskontrast von der Gitterperiode;
- Fig. 2a: eine schematische Darstellung eines dielektri- schen photonischen Kristalls mit rechteckigen Öffnungen;
- Fig. 2b: ein Transmissionsspektrum von auf den photoni- schen Kristall gemäß Fig. 2a einfallendem Licht;
- Fig. 3: eine schematische Seitenansicht eines integrier- ten Polarisationssensors gemäß Ausführungsbei- spielen der vorliegenden Erfindung;
- Fig. 4: eine Seitenansicht eines mit CMOS-Technik gefer- tigten Schichtstapels aus opto-elektronischem Bauteil, Metallschichten und dielektrischen Schichten, gemäß einem Alternativbeispiel der vorliegenden Beschreibung;
- Fig. 5: perspektivische Ansichten von Polarisationssenso- ren mit mehr als einer strukturierten Metall- schicht gemäß Alternativbeispieden der vorlie- genden Beschreibung;
- Fig. 6: eine vergleichende Darstellung einer in einem Standard-CMOS-hergestellten konventionellen Pho- todiode mit einem Polarisationssensor gemäß einem Alternativbeispiel der vorliegenden Beschreibung
- Fig. 7a: Transmissionsspektrum eines Polarisators mit nur einer strukturierten Metallschicht;
- Fig. 7b: Transmissionsspektrum eines Polarisators mit zwei strukturierten Metallschichten gemäß einem Aus- führungsbeispiel der vorliegenden Erfindung;
- Fig. 8: einen Polarisationskontrast als Funktion der Wel- lenlänge einer zweischichtigen Polarisations- struktur gemäß Ausführungsbeispielen der vorlie- genden Erfindung;
- Fig. 9a: eine schematische Draufsicht auf einen integrier- ten Polarisationssensor mit einer Mehrzahl von unterschiedlichen, benachbarten Polarisationssen- sorelementen, gemäß einem Alternativbeispiel der vorliegenden Beschreibung;
- Fig. 9b: eine schematische Draufsicht auf ein Polarisati- onselement gemäß einer Alternative zu Fig. 9a;
- Fig. 10: eine Darstellung einer mäanderförmig strukturier- ten Metallschicht, die zu einer Phasenverschie- bung zwischen TE- und TM-polarisiertem Licht führt;
- Fig. 11a: eine Wirkungsweise eines Polarisationssensors für elliptisch polarisiertes Licht;
- Fig. 11b: schematischer Aufbau eines Polarisationssensors für elliptisch polarisiertes Licht gemäß einem Ausführungsbeispiel der vorliegenden Erfindung;
- Fig. 12: eine schematische Darstellung eines Polarisati- ons-Bildsensors aus 5x5 Pixeln mit jeweils vier Polarisationssensoren gemäß einem Ausführungsbei- spiel der vorliegenden Erfindung;

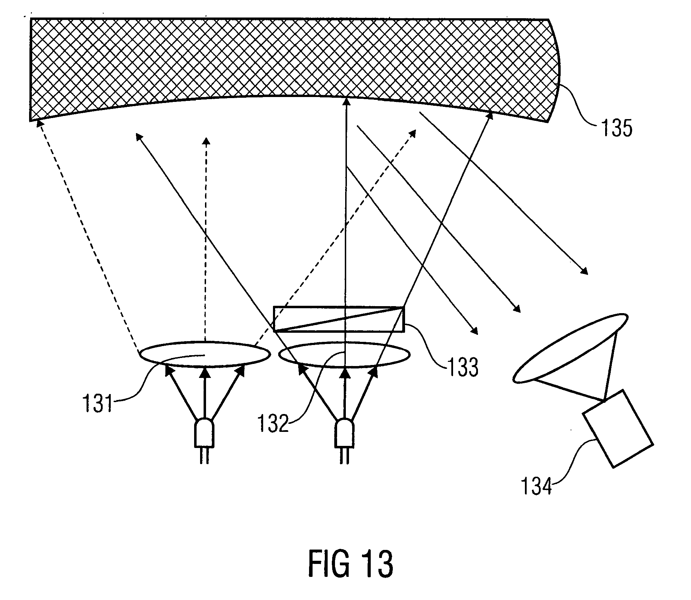

- Fig. 13: eine schematische Darstellung eines Fahrer- Assistenz-Systems mit einem Polarisations- Bildsensor gemäß einem Ausführungsbeispiel der vorliegenden Erfindung; und
- Fig. 14: a-e Transmissionskennlinien der Filterstrukturen aus Fig. 9a für verschiedene Seiten- bzw. Aspektverhältnisse jeweils für eine Polarisation einfallenden Lichtes von 0°, 22,5°, 45°, 67,5° und 90°;
- Fig. 15: eine Seitenansicht eines mit CMOS-Technik gefer- tigten Schichtstapels aus opto-elektronischem Bauteil und Schichten aus Metall oder polykristallinem Halbleitermaterial gemäß einem weiteren Ausführungsbeispiel der vorliegenden Er- findung; und
- Fig. 16: ein Transmissionsspektrum eines Polarisators in dem Fall der Verwendung der polykristallinen Schicht aus der CMOS-Technik von Fig. 15 als Fil- terstruktur.

Bezüglich der nachfolgenden Beschreibung sollte beachtet werden, dass bei den unterschiedlichen Ausführungsbeispielen gleiche oder gleichwirkende Funktionselemente gleiche Bezugszeichen aufweisen und somit die Beschreibungen dieser Funktionselemente in den verschiedenen nachfolgend dargestellten Ausführungsbeispielen untereinander austauschbar sind.

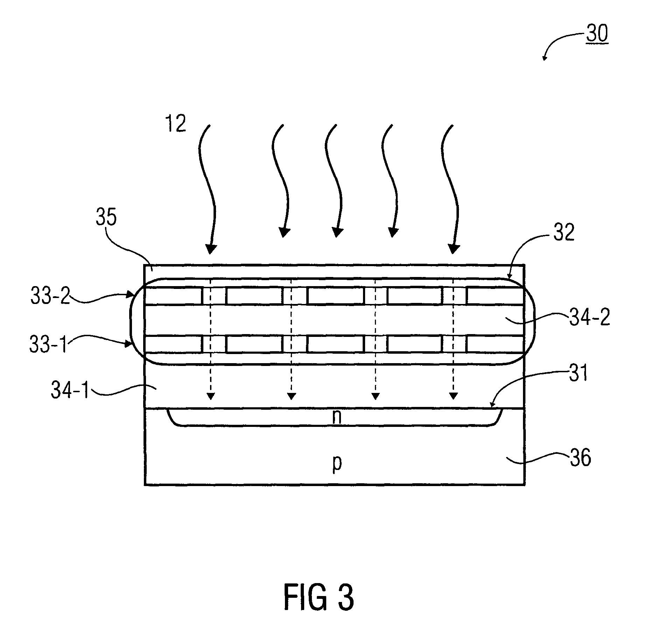

Fig. 3 zeigt eine schematische Seitenansicht eines Polarisationssensorelements 30, eines integrierten Polarisationssensors gemäß einem Ausführungsbeispiel der vorliegenden Erfindung.

Das Polarisationssensorelement 30 weist einen opto-elektronischen Sensor 31 und eine Polarisationsfilterstruktur 32 auf. Die Polarisationsfilterstruktur 32 umfasst wenigstens zwei vertikal übereinander liegende, strukturierte Metallschichten 33-1, 33-2. Zwischen dem opto-elektronischen Bauteil und der dem opto-elektronischen Bauteil 31 am nächsten angeordneten strukturierten Metallschicht 33-1 kann eine Schicht 34-1 aus einem dielektrischen Material angeordnet sein. Ebenso kann sich dielektrisches Material 34-2 zwischen den beiden vertikal übereinander liegenden strukturierten Metallschichten 32-1, 32-2 befinden. Oberhalb der obersten strukturierten Metallschicht 33-2 kann eine Passivierungsschicht 35 angeordnet sein. Der opto-elektronische Sensor 31 und die Polarisationsfilterstruktur 32 sind gemäß Ausführungsbeispielen gemeinsam auf einem Halbleitersubstrat 36 integriert.

Ansprechend auf elektromagnetische Strahlung 12, insbesondere Licht, das unterschiedliche Polarisationen aufweisen kann, ergibt sich durch die Filterstruktur 32 eine Transmission für eine vorbestimmte Polarisation der elektromagnetischen Strahlung 12 zu dem opto-elektronischen Sensor 31, wohingegen für andere Polarisationen als die vorbestimmte Polarisation die entsprechende elektromagnetische Strahlung von der Polarisationsfilterstruktur 32 reflektiert wird.

Die strukturierten Metallschichten 33-1, 33-2 können beispielsweise jeweils als Gitterstruktur ausgeführt sein. Durch die Verwendung von mehr als einer strukturierten Metallschicht können, im Vergleich zu nur einer strukturierten Metallschicht, relativ grobe Strukturen bzw. Strukturgrößen, wie z.B. Gitterperioden, verwendet werden. Für vorgegebene Strukturgrößen der strukturierten Metallschichten 33 steigt ein erzielbarer Polarisationskontrast der Polarisationsfilterstruktur 32 mit der Anzahl der übereinander liegenden, strukturierten Metallschichten 33.

Neben gitterförmigen Strukturen können andere polarisationsselektive Strukturen, wie z.B. kreuzförmige Strukturen, vorgesehen sein. Des weiteren können die strukturierten Metallschichten 33, zusammen mit den dazwischen liegenden dielektrischen Schichten 34, auch als photonischer Kristall ausgebildet sein, wie es im Vorhergehenden bereits beschrieben wurde.

Bei Ausführungsbeispielen der vorliegenden Erfindung bewirkt die Polarisationsfilterstruktur 32 mit den wenigstens zwei übereinander liegenden strukturierten Metallschichten 33 eine Polarisationsselektion einfallender elektromagnetischer Strahlung 12, so dass von dem unter den strukturierten Metallschichten 33 angeordneten opto-elektronischen Sensor 31, welcher ein PN-Übergangssensor, insbesondere eine Photodiode, sein kann, lediglich elektromagnetische Strahlung mit einer vorbestimmten Polarisation, die durch die Metallschichtstrukturen definiert wird, detektiert wird. Dabei kann es sich bei der vorbestimmten Polarisation um eine lineare Polarisation, um eine zirkulare Polarisation oder um eine elliptische Polarisation handeln.

Integrierte Polarisationssensoren, basierend auf einer Mehrzahl von strukturierten übereinander liegenden Metallschichten, lassen sich mit CMOS-Prozessen, wie beispielsweise einem CMOS-Opto-Prozess realisieren, ohne dass zusätzliche Prozessschritte oder weitere Bearbeitungen erforderlich sind.

Ein Verfahren zum Herstellen eines integrierten Polarisationssensors auf einem Substrat umfasst gemäß Ausführungsbeispielen einen Schritt des Erzeugens des opto-elektronischen Sensors 31 an einer Substratoberfläche des Substrats 36 und ein Aufbringen der Filterstruktur 32 mit wenigstens zwei übereinander liegenden strukturierten Metallschichten auf den opto-elektronischen Sensor 31, so dass der opto-elektronische Sensor 31 von der Filterstruktur 32 vollständig bedeckt wird, wobei das Erzeugen und das Aufbringen Teile eines CMOS-Prozesses sind.

Gemäß Ausführungsbeispielen umfasst das Aufbringen der Polarisationsfilterstruktur 32 ein Aufbringen eines Schichtstapels von dielektrischen Schichten und Metallschichten, wobei die Metallschichten jeweils Nanostrukturen aufweisen, welche Abmessungen und Abstände zwischen zwei benachbarten Nanostrukturen aufweisen, die eine Übertragung elektromagnetischer Strahlung eines vordefinierten Wellenlängenbereichs, z.B. sichtbares Licht, und eine Polarisation der elektromagnetischen Strahlung durch die Polarisationsfilterstruktur 32 erlauben.

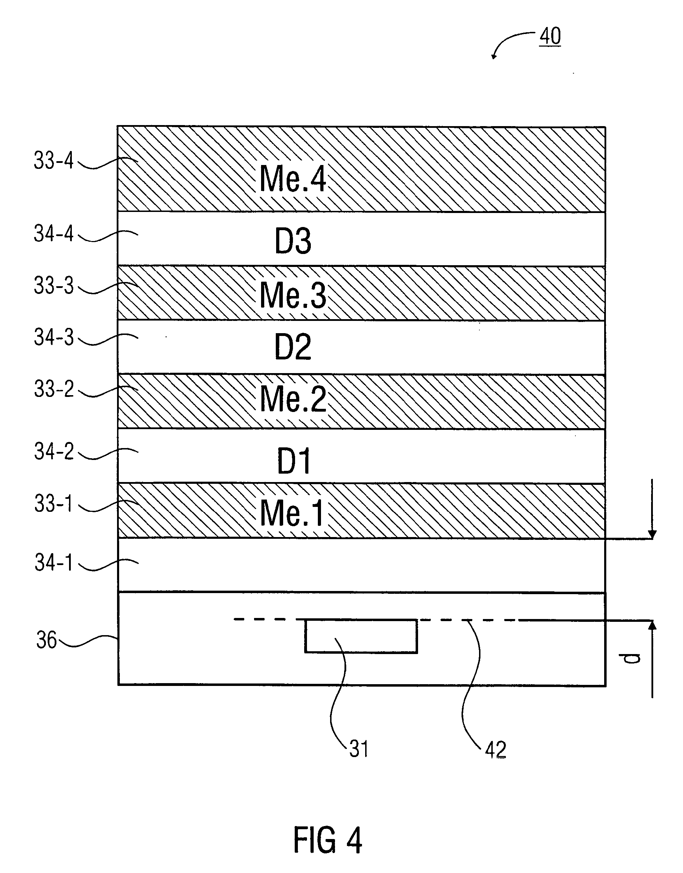

Ein Zwischenprodukt 40 eines integrierten Polarisationssensors gemäß Ausführungsbeispielen ist schematisch in Fig. 4 gezeigt.

Der in Fig. 4 gezeigte, noch nicht fertig hergestellte integrierte Polarisationssensor umfasst ein Substrat 36, insbesondere ein Halbleitersubstrat, in dem ein optoelektronischer Sensor 31 in einer Ebene 42 angeordnet ist. Die nicht fertig gestellte optische Struktur 40 weist einen Schichtstapel aus metallischen Schichten 33 und dielektrischen Schichten 34 auf. Fig. 4 zeigt lediglich exemplarisch vier metallische Schichten 33-1 bis 33-4 und vier dielektrische Schichten 34-1 bis 34-4. Je nach Ausführungsform kann die Schichtanzahl von dem in Fig. 4 gezeigten Beispiel abweichen.

Die oben beschriebenen Beispiele ermöglichen es, zu deren Realisierung auf Halbleiterstandprozesse zurückzugreifen, wie z.B. auf aktuelle CMOS-Prozessen. In anderen Worten ausgedrückt besteht mit CMOS-Prozessen die Möglichkeit, die Metallschichten 33-1 bis 33-4 so zu strukturieren, dass daraus resultierende Nanostrukturen bzw. Nanoelemente periodisch angeordnet sind und Abmessungen und Abstände aufweisen, die kleiner sind als Wellenlängen eines vorbestimmten Wellenlängenbereichs, insbesondere eines optischen Wellenlängenbereichs (Subwellenlängen)und dass beispielsweise dreidimensionale periodische Strukturen mit Eigenschaften von photonischen Kristallen direkt auf einem Chip erzeugt werden. Wie im Vorhergehenden bereits beschrieben wurde, sind bei den Beispielen die einzelnen Nanoelemente bzw. Nanostrukturen in der Größenordnung einer oder kleiner als eine Lichtwellenlänge, so dass ein dreidimensionaler photonischer Kristall durch die Filterstruktur 32 realisiert werden kann.

Gemäß Ausführungsbeispielen wird der opto-elektronische Sensor 31 vorzugsweise sehr nahe an der letzten Metallschicht 33-1 der Filterstruktur 32 platziert, wobei ein Abstand d abhängig vom Herstellungsprozess ist. Der Abstand d kann durch Abmessungen und Abstände von Strukturierungen der Metallschichten 33 eingestellt werden. Für einen integrierten Polarisationssensor wird daher der Abstand d < 20 µm und bevorzugt < 8 µm gewählt. Bei 0,18 µm CMOS-Prozessen ist der Abstand zwischen dem opto-elektronischen Sensor 31 und der Filterstruktur 32 bzw. der letzten Metallschicht 33-1 < 2 µm.

Die in Fig. 4 exemplarisch gezeigten Metallschichten 33 werden in einem CMOS-Prozess geeignet strukturiert, um eine Polarisationsfilterstruktur mit guten Polarisationseigenschaften (z.B. Polarisationskontrast) zu erhalten, so dass keine zusätzlichen optischen Aufbauten benötigt werden. Ein integrierter Polarisationssensor 30 gemäß Ausführungsbeispielen kann also realisiert werden, indem man die in einem CMOS-Prozess sowieso vorhandenen metallischen und dielektrischen Schichten 33, 34 ausnutzt. Bei Ausführungsbeispielen ist der opto-elektronische Sensor 31 der einzige opto-elektronische Sensor, insbesondere eine Photodiode, eines integrierten Polarisationssensors. Dabei überlappt der opto-elektronische Sensor 31 lateral mit der Polarisationsfilterstruktur 32 und ist individuell ansteuerbar. Der opto-elektronische Sensor 31 ist gemäß Ausführungsbeispielen vorzugsweise von den strukturierten Metallschichten 33 vollständig abgedeckt.

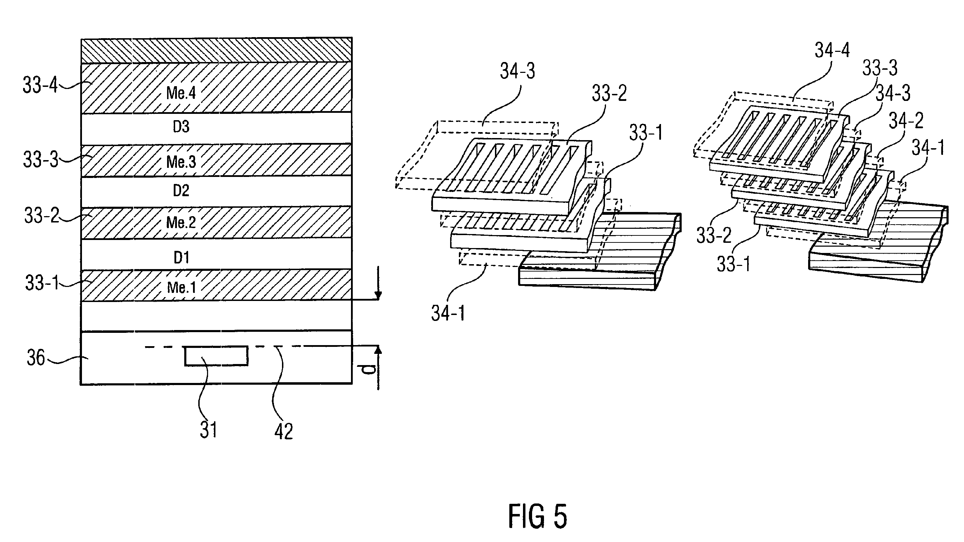

Fig. 5 zeigt, neben der Seitenansicht des Zwischenprodukts 40 von Fig. 4, eine perspektivische Ansicht von übereinander liegenden strukturierten Metallschichten 33 mit dazwischen liegenden dielektrischen Schichten 34.

In Fig. 5 (rechts) sind schematisch zwei Beispiele dargestellt, eines für zwei strukturierte Metallschichten 33-1 und 33-2, und ein weiteres für drei strukturierte Metallschichten 33-1 bis 33-3. Die Verwendung von zwei strukturierten Metallschichten führt zu einem deutlich erhöhten Polarisationskontrast gegenüber herkömmlichen Polarisatoren mit nur einer strukturierten Metallschicht. Gleichermaßen führt die Verwendung von drei strukturierten Metallschichten wiederum zur Erhöhung eines Polarisationskontrasts gegenüber Ausführungsbeispielen mit nur zwei strukturierten Metallschichten.

Eine Polarisationsfilterstruktur 32 umfasst periodisch angeordnete strukturierte Metallschichten 33 in einem dielektrischen Medium 34, wie z.B. Silizium-Dioxid (SiO₂). Die strukturierten Metallschichten 33 weisen Nanostrukturen auf, so wie es in Fig. 5 (rechts) angedeutet ist. Die geometrische Form dieser Nanostrukturen kann vielfältig ausgestaltet sein und hängt von den gewünschten Polarisationseigenschaften der Polarisationsfilterstruktur 32 ab. Möglich sind beispielsweise gitterförmige Nanostrukturen oder rechteckförmige Nanoöffnungen, deren Abmessungen und Abstände zueinander kleiner als die Wellenlänge des einfallenden Lichts 12 sind. Ein Abstand zwischen benachbarten strukturierten Metallschichten 33 liegt ebenfalls in der Größenordnung der Wellenlänge des einfallenden Lichts.

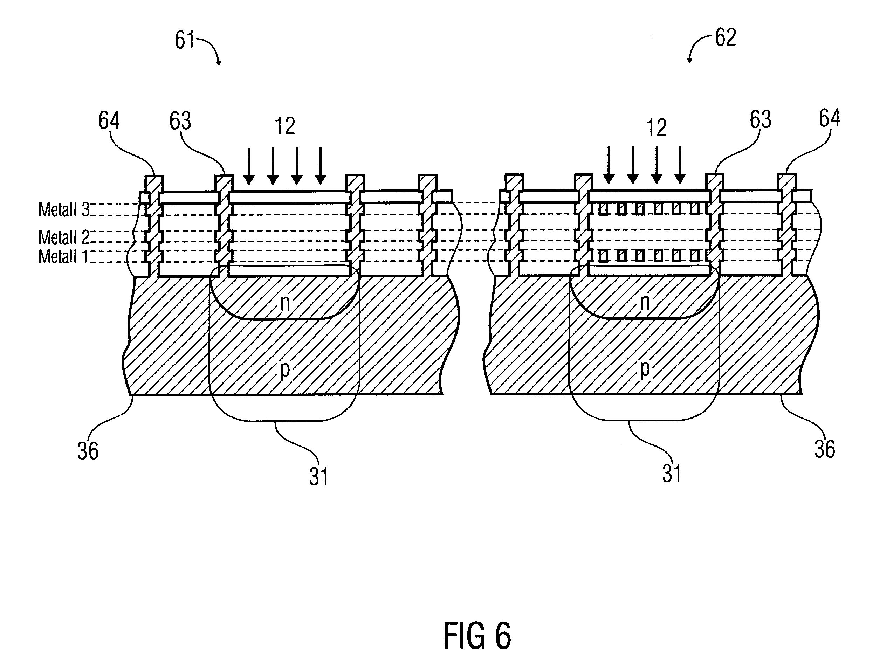

Mit Ausführungsbeispielen der vorliegenden Erfindung ist es also möglich, einen Polarisationssensor aufzubauen, der keine zusätzlichen optischen Filterschichten benötigt, sondern in dem als polarisationsselektives Element 32 geeignete Subwellenlängenstrukturen innerhalb der vorhandenen Metallschichten 33 (und ggf. dielektrische Schichten 34) eines Halbleiterprozesses ausgebildet werden. Dazu zeigt Fig. 6 schematisch eine Gegenüberstellung einer herkömmlichen in CMOS-Technologie realisierten Photodiode (links) und eines integrierten Polarisationssensors gemäß einem Ausführungsbeispiel der vorliegenden Erfindung (rechts).

Die integrierte Schaltung 61 weist ein p-dotiertes Halbleitersubstrat 36 auf, in das eine n-dotierte Wanne eingebracht ist, wodurch ein pn-Übergangssensor 31, insbesondere eine pn-Photodiode, gebildet wird. Der n-dotierte Bereich des opto-elektronischen Sensors 31 wird durch eine Elektrode 63 (Kathode) kontaktiert, der p-dotierte Bereich wird durch eine Elektrode 64 (Anode) kontaktiert. Die beiden Kontakte 63 bzw. 64 werden jeweils durch strukturierte Metallschichten und metallischen Durchkontaktierungen zwischen den unterschiedlichen Metallschichten gebildet. Bei herkömmlichen Schaltungsanordnungen ist der Bereich, in dem Licht 12 auf die Photodiode 31 fällt, frei von Metallkontakten. Nur am Rand werden die Metallschichten zur Kontaktierung verwendet (siehe Fig. 6, links).

Bei einer integrierten Schaltung 62 gemäß einem beispiel der vorliegenden Erfindung werden über der Photodiode 31 wenigstens zwei übereinander liegende strukturierte Metallschichten 33 eingesetzt, so wie es in Fig. 6, rechts, gezeigt ist. Dabei werden die Metalllagen 33 derart strukturiert, dass eine polarisationsselektive Wirkung erreicht wird. Durch die Kombination der daraus resultierenden Polarisationsfilterstruktur mit dem lichtempfindlichen Empfänger 31, der ebenfalls mit Hilfe des verwendeten Halbleiterprozesses hergestellt wird, kann ein integrierter Polarisationssensor gemäß Ausführungsbeispielen aufgebaut werden. Dieser kann zudem in vielfältiger Form strukturiert, angeordnet und mit anderen polarisationssensitiven Elementen auf einem Halbleiterchip kombiniert werden.

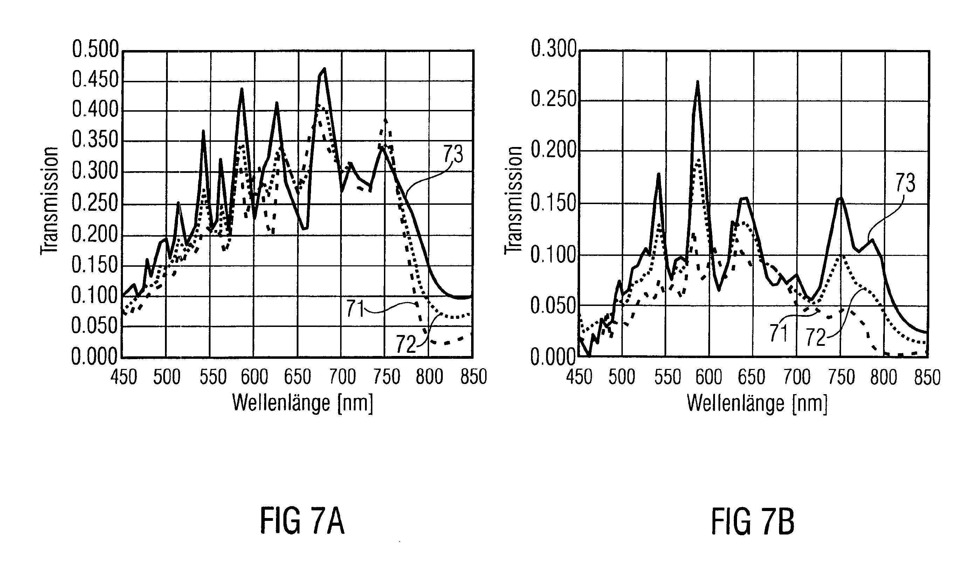

Fig. 7a,b zeigen einen Vergleich von Transmissionsmessungen eines herkömmlichen Polarisationsfilters mit nur einer gitterförmig strukturierten Metallschicht zu einem integrierten Polarisationssensor mit zwei gitterförmig strukturierten übereinander liegenden Metallschichten (Gitterperiode jeweils 540 nm).

Fig. 7a zeigt Transmissionskurven einer Polarisationsstruktur mit nur einer gitterförmig strukturierten Metallschicht. Dabei bezeichnen die Kurven 71 und 73 jeweils linear polarisiertes Licht mit zueinander senkrechten Polarisationsrichtungen und die Kurve 71 unpolarisiertes Licht.

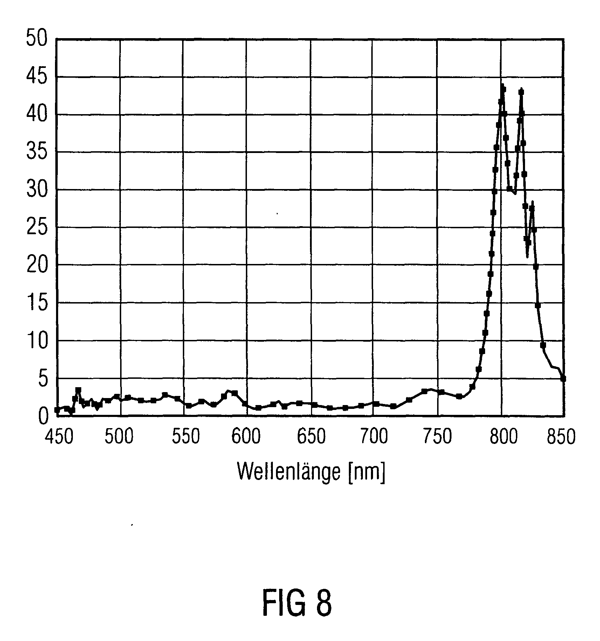

Fig. 7b stellt die jeweiligen Transmissionskurven für eine Polarisationsfilterstruktur mit zwei übereinander liegenden, gitterförmig strukturierten Metallschichten gemäß einem Ausführungsbeispiel der vorliegenden Erfindung dar. Es lässt sich erkennen, dass der Polarisationskontrast, d.h. das Verhältnis der Transmission der beiden Polarisationen, bei zwei strukturierten Metallschichten bei gleicher Gitterperiode deutlich erhöht ist. In Fig. 7a ist der Polarisationskontrast maximal ca. 5:1 bei einer Wellenlänge von etwa 800 nm. Im Fall von Fig. 7b ist der Polarisationskontrast je nach Wellenlänge dagegen bis zu 45:1, was in Fig. 8 nachverfolgt werden kann.

Bemerkenswerter Weise ergibt sich aus obiger Analyse, dass die Verwendung mehrerer hintereinander angeordneter strukturierter Metallschichten nur zu einer relativ geringen Verringerung der Transmissionseigenschaft bzw. Empfindlichkeit führen, wohingegen der Polarisationskontrast aber stark zunimmt. Bei zwei Schichten liegt der Intensitätsverlust beispielsweise nur bei einem Faktor von etwa einem Drittel, während der Kontrastanstieg einen Faktor von etwa zehn beträgt.

Wie im Vorhergehenden bereits beschrieben wurde, sind neben einfachen Liniengitterstrukturen der Metallschichten der Polarisationsfilterstruktur 12 auch durch die Polarisationsfilterstruktur 12 realisierte photonische Kristalle, die mit den Metallstrukturen in CMOS hergestellt werden, denkbar. Dabei ist ein derartiger photonischer Kristall aus der Schichtenfolge von metallischen und dielektrischen Schichten aufgebaut. Dabei sind die Nanostrukturen eines photonischen Kristalls gemäß Alternativbeispieden nicht 90°-drehinvariant ausgebildet.

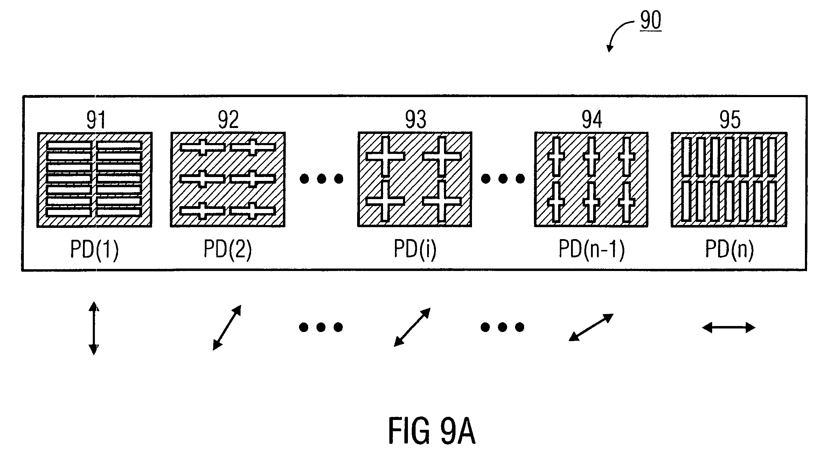

Es können spezielle Strukturen verwendet werden, die für vorbestimmte Polarisationswinkel des einfallenden Lichts 12 optimiert sind. Der einfachste Ansatz, Wellenlängenstrukturen in den übereinander liegenden strukturierten Metallschichten 33 zu realisieren, die für bestimmte Polarisationswinkel optimiert sind, besteht darin, Liniengitter mittels der strukturierten Metallschichten 33 zu realisieren, die um den zu detektierenden Polarisationswinkel verdreht sind. Allerdings verbieten in fast allen Fällen Prozessbeschränkungen bei der CMOS-Technologie Metallstege mit beliebigen Winkeln zu realisieren. So sind mögliche Winkel für Polygone oft nur auf 0°, 45° und 90° begrenzt. Gemäß Beispielen der vorliegenden Beschreibung können stattdessen eine Reihe asymmetrischer Strukturen realisiert werden, welche verschieden gewählte Seitenverhältnisse aufweisen. Diese asymmetrischen Strukturen zeigen dann, abhängig von den gewählten Seitenverhältnissen, für unterschiedliche Polarisationswinkel die größte Transmission. Derartige asymmetrische Strukturen sind beispielhaft in Fig. 9a gezeigt.

Simulationen zeigen, dass Struktur 91 mit horizontalen Liniengittern vertikal polarisiertes Licht am besten hindurchlässt. Mit variierendem Seitenverhältnis zweier gekreuzter Spalte, wie in den Strukturen 92, 93 und 94 zu erkennen, nimmt die Empfindlichkeit für Licht mit größerem Polarisationswinkel zu, bis sie für horizontal polarisiertes Licht maximal ist (Struktur 95 mit vertikalen Gitterlinien).

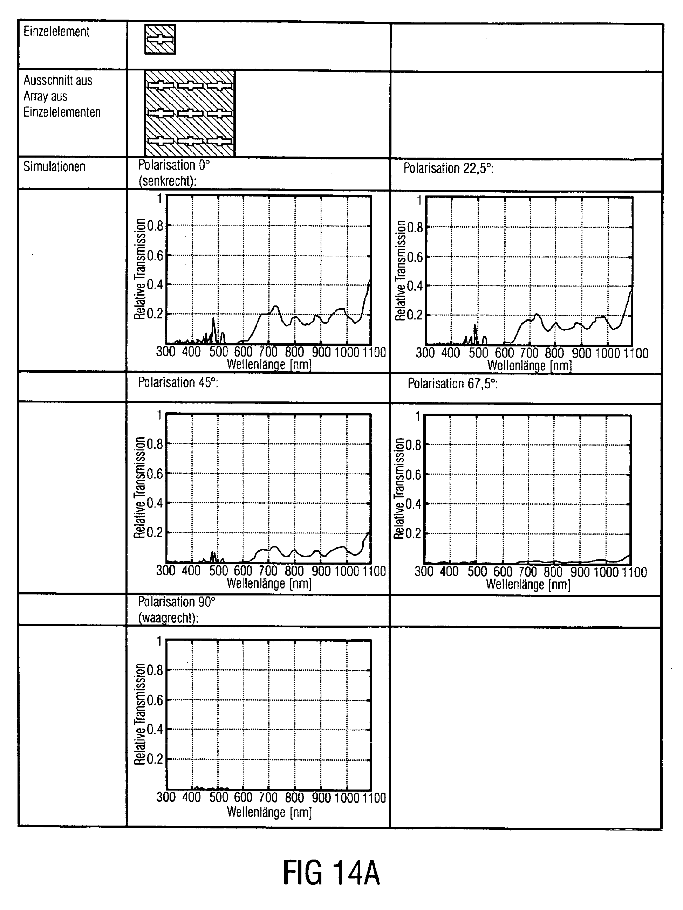

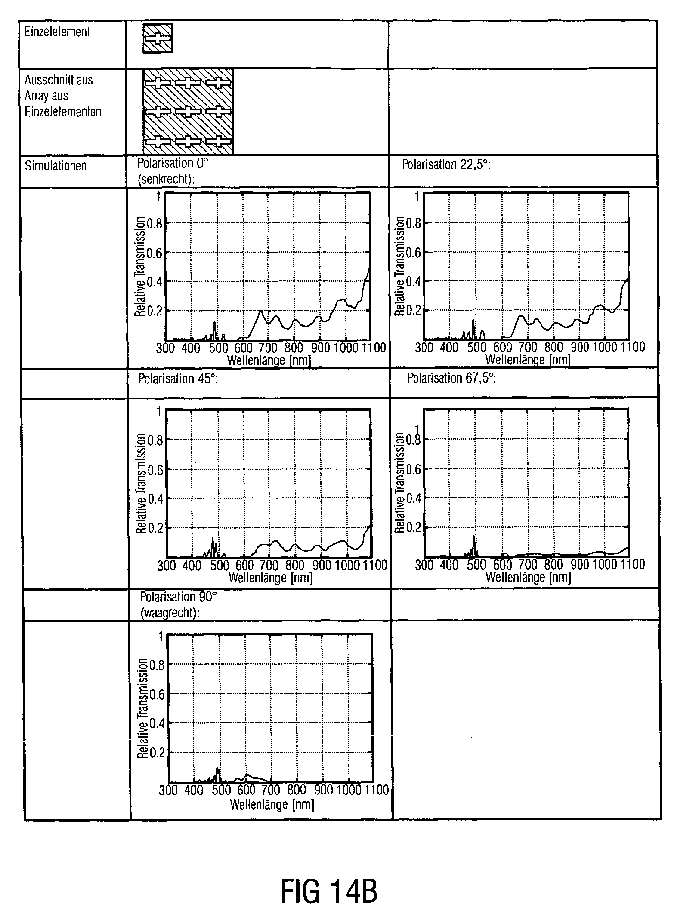

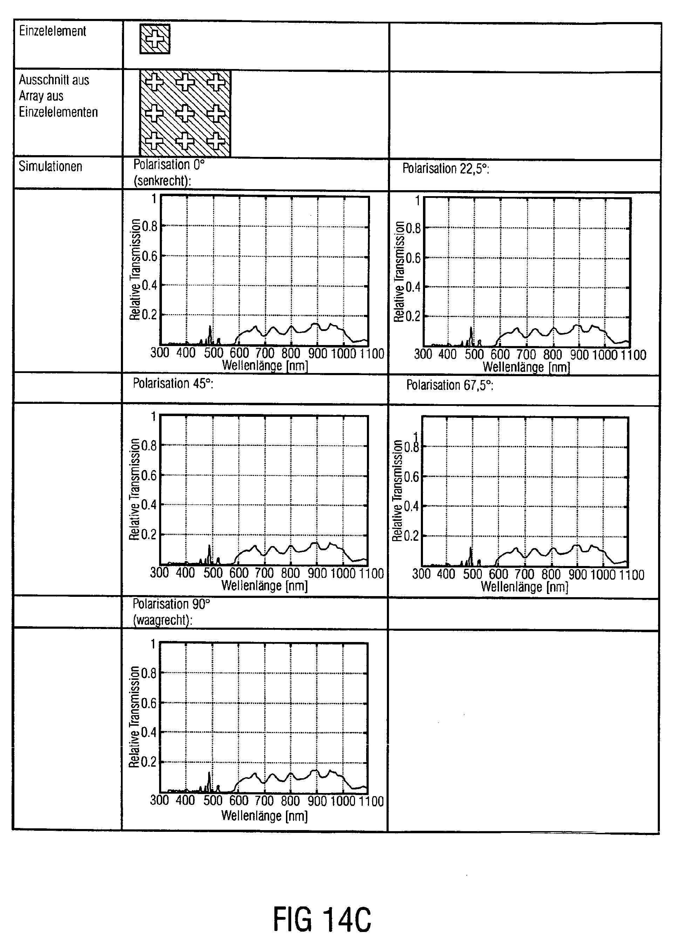

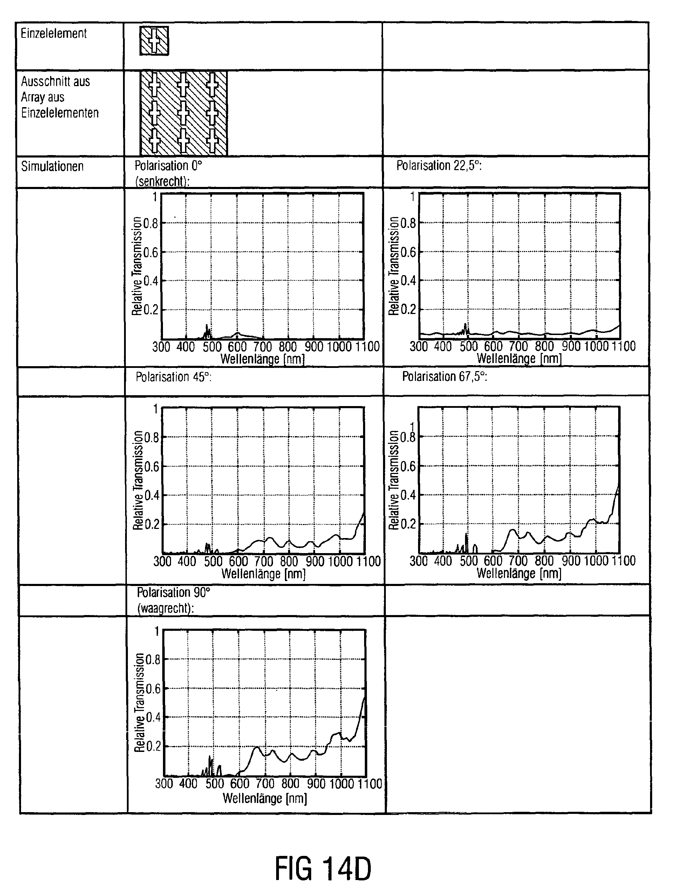

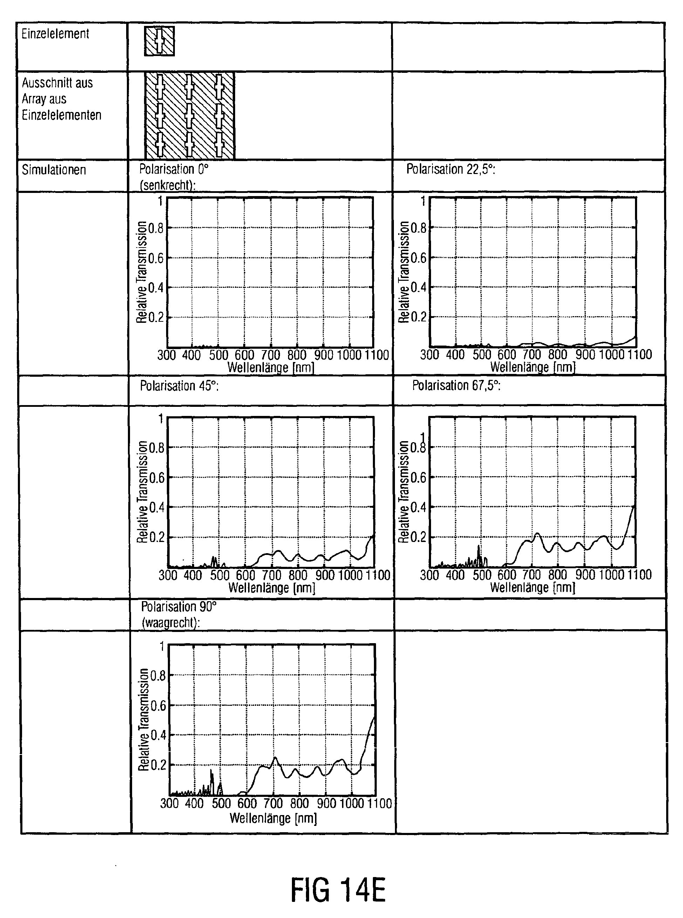

Dies veranschaulichen die Figuren 14a-14e. Diese zeigen für die kreuzförmigen Öffnungen aus Fig. 9a, dass mit zunehmendem Aspektverhältnis bzw. Seitenverhältnis, d.h. mit zunehmendem Verhältnis der waagrechten Ausdehnung zur senkrechten Ausdehnung bzw. umgekehrt, die Polarisationsempfindlichkeit zunimmt. So zeigt die Filterstruktur aus einem Array von im Wesentlichen waagrechten, länglichen Kreuzen eine Transmissionsfähigkeit ab etwa 650 nm für eine laterale Polarisationsrichtung von 0°, wobei die Transmissionsfähigkeit für hiervon abweichende Polarisationsrichtungen schnell abnimmt, um bei einer Polarisationsverkippung von 90° nicht mehr vorhanden zu sein. Bei den Simulationen betrug der Wiederholabstand der kreuzförmigen Öffnungen 350 nm horizontal und vertikal, die Balkenbreite 50 nm und die Balkenlänge der längeren Ausdehnung 300 nm. Kehrt man das Seitenverhältnis um, d.h. betrachtet man das im Wesentlichen senkrechte, längliche Element, so zeigt Fig. 14e, dass eine sich aus einem Array dieser Elemente zusammensetzende Filterstruktur genau das umgekehrte Verhalten zeigt, nämlich eine hohe Transmission für Licht mit einem Polarisationswinkel von 90° und keine Transmission für Licht mit Polarisation 0°. Beträgt das Seitenverhältnis 1:1 bzw. das Aspektverhältnis 1:1, welcher Fall in Fig. 14c dargestellt ist, so ist das Transmissionsspektrum Polarisationsrichtungs-invariant. Die Figuren 14b und 14d stellen nun die Zwischenverhältnisse dar, insofern, als dort das Aspektverhältnis zwischen denjenigen aus Figuren 14a und 14e einerseits und Figur 14c andererseits liegt. Wie es zu sehen ist, ist die Polarisationsrichtungssensitivität etwas verringert. Das erkennt man insbesondere bei der Polarisationsrichtung, bei der bei dem hohen Aspektverhältnis keine Transmission vorhanden ist, wohingegen in den Figuren 14b und 14d auch bei diesen Richtungen noch eine Transmission bei beispielsweise 600 nm sichtbar ist.

Statt der in Fig. 9a lediglich exemplarisch gezeigten Strukturen können auch weitaus mehr Strukturen realisiert werden, beispielsweise in einem zweidimensionalen Array aus 10x10 Strukturen, von denen jede z.B. 100x100 µm groß ist, was zu einer Gesamtfläche des integrierten Polarisationssensors von 1 mm² führt. Unterschiedliche Strukturen können bei Licht mit unterschiedlichen Polarisationswinkeln vermessen und der Polarisationssensor damit einmalig kalibriert und ein entsprechendes Gleichungssystem aufgestellt und gelöst werden. Bei dem in Fig. 9a gezeigten Beispiel werden dann z.B. fünf Ausgangssignale der den fünf verschiedenen Strukturen zugeordneten Fotodioden herangezogen und daraus der Polarisationswinkel und eventuell auch die Amplitude bzw. die Intensität des einfallenden Lichts berechnet bzw. bestimmt. Die Genauigkeit ist dabei umso höher, je besser das Gleichungssystem konditioniert ist (geringe lineare Abhängigkeit), und je mehr Ausgangssignale bei der Auswertung beteiligt sind.

Die vorerwähnte Berechnung oder Bestimmung, wie z.B. mittels Nachschlagen der Polarisationsrichtung der einfallenden Strahlung auf Basis einer normierten Version der Ausgangssignale, wie sie durch die unterschiedlichen Strukturen erhalten worden sind, kann beispielsweise durch eine in dem integrierten Polarisationssensor integrierte Schaltung durchgeführt werden.

Eine Bestimmung eines Polarisationswinkels von einfallendem Licht ist prinzipiell bereits durch eine Verwendung einer Transmissionsmessung mit Hilfe zweier senkrecht zueinander stehender Polarisationsfilter möglich (Bestimmung der beiden Projektionen der Feldkomponenten). Dies kann beispielsweise durch zwei orthogonal angeordnete Liniengitter realisiert werden. Für Anwendungen wie z.B. Polarimeter, wo der Polarisationswinkel auf z.B. 0,001° genau bestimmt werden muss, ist die auf diese Weise zu erreichende Genauigkeit jedoch unzureichend. Nach dem Stand der Technik wird daher in solchen Anwendungsfällen der Polfilter, der als Analysator dient, mechanisch gedreht und dann die gemessene Transmission gegen den Drehwinkel aufgetragen. Durch Anfitten kann dann ein Minimum bzw. Maximum des Signals sehr genau bestimmt werden und damit der Polarisationswinkel sehr viel genauer gemessen werden als bei der Messung zweier orthogonaler Feldkomponenten bei nur zwei Stellungen des analysierenden Polfilters, was wiederum einer Messung mit zwei senkrecht stehenden Liniengittern entspricht. Alternativbeispiele der vorliegenden Beschreibung ermöglichen nun, eine genauere Messung des Polarisationswinkels aufgrund einer Messung mit vielen unterschiedlich gestalteten Strukturen, die für verschiedene Polarisationswinkel optimiert sind (siehe Fig. 9a). Ein Anfitten der Messung mit vielen dieser Strukturen, statt der Bestimmung von nur zwei orthogonalen Feldkomponenten, ermöglicht eine signifikante Erhöhung der Genauigkeit, wie sie in vielen Anwendungsfällen benötigt wird.

Ausführungsbeispiele der vorliegenden Erfindung können auch eingesetzt werden, um Polarisationssensoren zu schaffen, die auch elliptisch polarisiertes Licht detektieren können, z.B. zirkular polarisiertes Licht als dessen Spezialfall. Eine Lösung mit konventionellen optischen Polarisationsfiltern würde einen komplizierten Aufbau mit optischen Verzögerungsplatten, λ/4-Plättchen, erfordern.

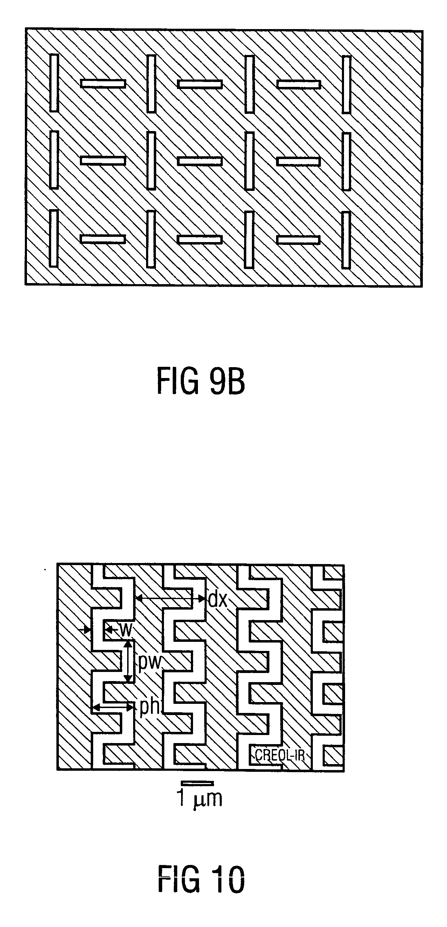

Es sind flächenhafte mäanderförmige Metallstrukturen bekannt (Jeffrey S. Tharp, Brian A. Lail, Ben A. Munk, Glenn D. Boreman: "Design and Demonstration of an Infrared Meanderline Phase Retarder", IEEE Transactions on Antennas and Propagation, Vol. 55, NO. 11, November 2007), die als Verzögerungsplatten, insbesondere als λ/4-Verzögerungsplatten, arbeiten. Eine mäanderförmige Metallstruktur wirkt als ein Phasenverzögerer für die zwei orthogonal aufeinander stehenden Wellenkomponenten, die entlang und senkrecht zu der Mäanderachse polarisiert sind. Dabei wirkt eine mäanderförmige Metallstruktur hauptsächlich als ein induktives Element entlang der Mäanderachse und als ein kapazitives Element senkrecht zur Mäanderachse, wodurch eine relative Phasenverzögerung für die orthogonalen Polarisationskomponenten erzeugt wird. Das heißt, einfallendes Licht erfährt eine Phasenverzögerung, die von der Polarisation abhängt, wobei der relative Phasenunterschied zwischen TE- und TM-Polarisation sich im Idealfall genau um 90° unterscheidet (Doppelbrechung). Ausführungsbeispiele der vorliegenden Erfindung nutzen dieses Wirkprinzip. Dazu wird in einer Metallschicht z.B. eines CMOS-Elements eine mäanderförmige Metallstruktur realisiert, wie sie beispielhaft in Fig. 10 gezeigt ist. Vorzugsweise wird eine oberste Metallschicht mäanderförmig strukturiert. Wie bereits erwähnt liegen die Strukturgrößen dx, w, pw, ph unterhalb der Wellenlänge des verwendeten Lichtes und können um so größer sein, je mehr strukturierte Metallebenen verwendet werden.

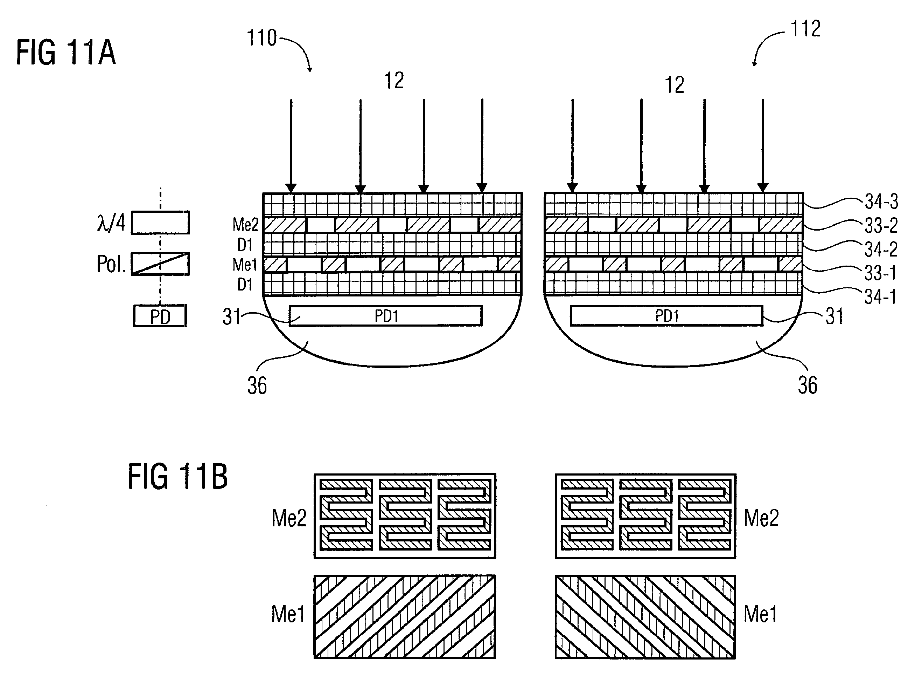

Dies führt dazu, dass aus einfallendem Licht 12, das zirkular polarisiert sein kann, nach Durchtritt durch die mäanderförmige Metallstruktur linear polarisiertes Licht entsteht. Dieses wird in einer weiteren, darunter liegenden Metallschicht analysiert, und zwar durch eine Struktur, die linear polarisiertes Licht detektieren kann. Dieses Prinzip ist schematisch in Fig. 11a gezeigt. Die Richtung der zirkular polarisierten Wellen (links-zirkular bzw. rechts-zirkular polarisiertes Licht) kann aus dem gemessenen Winkel des linear polarisierten Lichts (-45° bzw. +45°) bestimmt werden.

Ausführungsbeispiele der vorliegenden Erfindung kombinieren also quasi ein λ/4-Plättchen, ein lineares Polarisationsfilter und einen lichtempfindlichen Empfänger in einem einzigen Bauelement. Fig. 11b zeigt einen integrierten Polarisationssensor mit zwei Polarisationssensorelementen 110, 112, wobei ein erstes Polarisationssensorelement 110 für rechts-zirkular polarisiertes Licht und das zweite Polarisationssensorelement 112 für links-zirkular polarisiertes Licht ausgelegt ist. Die beiden Polarisationssensorelemente sind dabei auf ein gemeinsames Halbleitersubstrat 36 integriert und verfügen jeweils über einen eigenen opto-elektronischen Sensor 31.

Das Polarisationssensorelement 110 unterscheidet sich von dem Polarisationssensorelement 112 in einer Ausrichtung der Metallgitterlinien der jeweils unteren strukturierten Metallschicht (ME1) 33-1, wie es in Fig. 11b unten dargestellt ist. Die darüber liegende strukturierte Metallschicht, welche jeweils mäanderförmig strukturiert ist, ist bei beiden Polarisationssensorelementen 110, 112 gleich ausgeführt. Selbstverständlich sind für die Strukturen der Metallschichten 33-1, 33-2 auch andere als die gezeigten Strukturen denkbar.

Eine Anpassung der Strukturen an eine gewünschte Lichtwellenlänge erfolgt durch geeignete Wahl der geometrischen Parameter der Metallstrukturen.

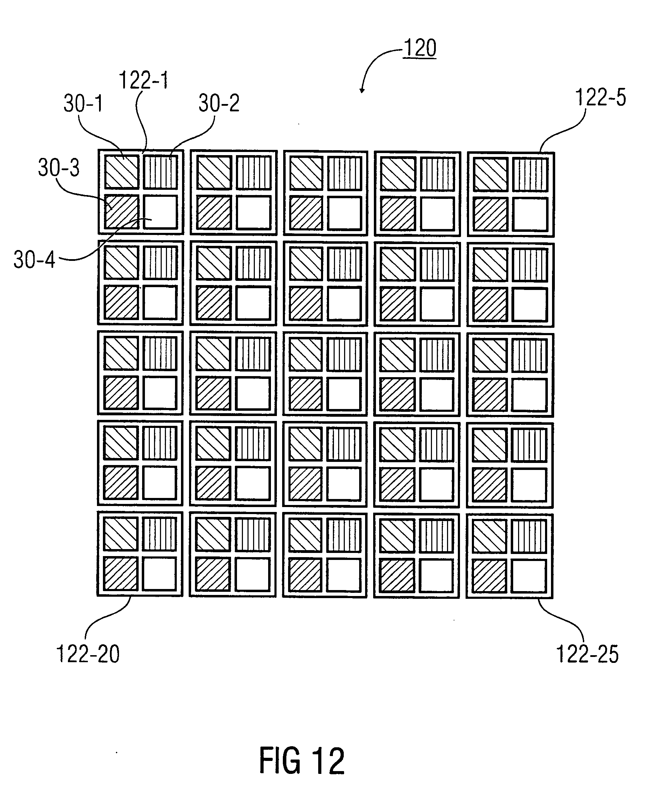

Eine Mehrzahl von Polarisationssensorelementen kann gemäß Ausführungsbeispielen auch zu einem Polarisationsbildsensor kombiniert werden, wie er schematisch in Fig. 12 gezeigt ist.

Ferner ist es möglich basierend auf einer Mehrzahl von Polarisationssensorelementen gemäß obigen Ausführungsbeispielen alle vier Komponenten eines Stokes-Vektors zu bestimmen, der den Polarisationszustand des einfallenden Lichtes bekanntlich vollständig beschreibt, indem nämlich auch die Messung zirkular polarisierten Lichtes durchgeführt wird.

Der Polarisationsbildsensor 120 umfasst beispielhaft eine 5x5 Matrix aus 25 Superpixeln 122, wobei jedes Superpixel vier Polarisationssensorelemente 30 für unterschiedliche Polarisationen umfasst. Ein erstes Polarisationssensorelement 30-1 dient zur Detektion von Polarisationen von 0°, ein zweites Polarisationssensorelement 30-2 dient zur Detektion von Polarisationen um 90°, ein drittes Polarisationssensorelement 30-3 dient zur Detektion von Polarisationen um 135° und ein viertes Sensorelement 30-4, welches keine strukturierten Metallschichten aufweist, dient zur Detektion von unpolarisiertem Licht.

Einzelne Polarisationssensorelemente, die jeweils für eine unterschiedliche Polarisationsrichtung empfindlich sind, können also als Array auf einem Chip angeordnet werden. Dadurch können die folgenden Auswertemöglichkeiten entstehen. Es können gleichzeitig viele verschiedene Polarisationsrichtungen erkannt und gemessen werden, und es kann durch Interpolation der einzelnen Messwerte ein eventuell zu messende, zwischen den Richtungen der Polarisationssensorelemente 30 liegende Polarisationsrichtung mit hoher Genauigkeit berechnet werden. Ein Array aus z.B. vier Polarisationssensorelementen 30 kann so aufgebaut sein, dass ein Element keinen Filter aufweist (zur Erkennung der Intensität polarisationsunabhängig), ein Element eine um 0°, eines um 90° und eines die um 45° gedrehte Polarisation misst. Aus diesem Grundelement bzw. Superpixel mit vier Polarisationssensorelementen kann dann ein zweidimensionaler Bildsensor gebaut werden, der gleichzeitig Bilder von mehreren unterschiedlichen Polarisationswinkeln aufnehmen kann. Durch die Kombination dieser einzelnen Bilder kann der Kontrast des Bildes deutlich erhöht bzw. störende Reflexe ausgeblendet werden. Alle Polarisationssensorelemente können mit Signalverarbeitungsschaltung auf einem Chip integriert werden, die die weitere Auswertung der Sensorsignale übernehmen.

Ein Polarisationsbildsensor gemäß Fig. 12 kann beispielsweise in einem Fahrerassistenz-System eingesetzt werden, um beispielsweise Polarisationseigenschaften des von der Straßenoberfläche reflektierten Lichts zu bestimmen, wodurch auf den Straßenzustand geschlossen werden kann. Ein derartiges Fahrerassistenz-System 130 weist zwei Lichtquellen 131, 132 auf, mit jeweils unterschiedlichen Wellenlängen, vorzugsweise aus dem IR-Spektralbereich, um entgegenkommende Fahrzeuge nicht zu blenden. Die erste Lichtquelle 131 kann beispielsweise für Abstandsmessungen herangezogen werden, wohingegen die zweite Lichtquelle 132 für Polarisationsmessungen verwendet werden kann. Vor die Lichtquelle 132 ist ein Polarisationsfilter 133 geschaltet, so dass das ausgehende Licht linear polarisiert werden kann. Ein Empfangssystem 134 kann einen 3D-Sensor aufweisen, der eine Auswertung des reflektierten Lichts liefert. Das Empfangssystem kann einem Fahrer beispielsweise ein 3D-RGB sowie ein Infrarot-Bild liefern. Durch Integration eines erfindungsgemäßen Polarisationssensors in das Empfangssystem 134 können dem Fahrer zusätzlich noch Informationen über den Straßenzustand geliefert werden. Ferner ist das Empfangssystem 134 mit einem Kommunikationssystem ausgerüstet, so dass es mit anderen Entfernungssystemen von entgegenkommenden Fahrzeugen kommunizieren kann. Senden beispielsweise zwei entgegenkommende Fahrzeuge mit gleicher Polarisation, so kann die Polarisation des ausgesendeten Lichts bei einem Fahrzeug gegenüber dem anderen Fahrzeug um 90° umgeschaltet werden, um ein Blenden des Fahrerassistenz-Systems des anderen Fahrzeugs zu vermeiden. Die Entfernungsmessung kann nach Art eines Photonic Mixer Devices geschehen. In anderen Worten ausgedrückt werden beispielsweise in jedem i-ten Superpixel 122 in Zeilenrichtung und jedem j-ten Superpixel in Spaltenrichtung mit i,j >= 1 die anfallenden Sensorinformationen eines oder mehrerer der dortigen Subpixel 30 dazu verwendet, auf einen Abstandwert oder Tiefeninformationswert rückzuschließen, so dass gleichzeitig 3D-Bilder mit Polarisationsauflösung erhalten werden. Beispielsweise wird mittels einer gepulsten Beleuchtung und einer Shutter-Aufnahme eine Laufzeitmessung pro i/j-tem Pixel durchgeführt. Natürlich wäre auch eine Triangulationsmessung mittels laterale variierender Beleuchtung möglich. Die Eigenschaft bestimmter zu beobachtender Objekt im Hinblick auf die Reflexionseigenschaften Ihrer Oberfläche könnte dazu verwendet werden, dass das Signal-Rausch-Verhältnis der Tiefenmessungen verbessert wird. Beispielsweise wird dazu abhängig von den Tiefenmessergebnissen oder sonst wie aus den Intensitäten, die aus den einzelnen Subpixeln erhalten werden, entschieden, welches oder welche der Subpixel eines Superpixels zur Tiefenmessung verwendet wird.

Die Lichtquelle 132 und das Polarisationsfilter 133 können gemäß Ausführungsbeispiel der vorliegenden Erfindung auch zu einem integrierten Bauteil kombiniert werden, das einen opto-elektronischen Sender und eine Polarisationsfilterstruktur mit wenigstens zwei vertikal übereinander liegenden strukturierten Metallschichten aufweist, wobei die wenigstens zwei vertikal übereinander liegenden strukturierten Metallschichten ansprechend auf eine elektromagnetische Strahlung mit einer vorbestimmten Polarisation eine höhere Transmission durch die Polarisationsfilterstruktur von dem opto-elektronischen Sender ergeben als für von der vorbestimmten Polarisation abweichende Polarisationen, und wobei der opto-elektronische Sender und die Polarisationsfilterstruktur gemeinsam auf einem Halbleitersubstrat integriert sind.

Bei dem opto-elektronischen Sender kann es sich beispielsweise um eine integrierte LED (Light Emitting Diode) handeln.

Derzeit können Polarisationsbilder nur mit einem CCD- oder CMOS-Bildsensor und vorgelagerten Polarisationsfiltern aufgenommen werden. Wenn der Bildkontrast erhöht werden soll, müssen hier mehrere Bilder hintereinander aufgenommen werden, wobei zwischen den Aufnahmen mit einem mechanischen Versteller der Polfilter zu drehen ist. Durch Ausführungsbeispiele der vorliegenden Erfindung können Polarisationsbilder gleichzeitig in einem Schuss und ohne mechanisch bewegte Teile aufgenommen werden, was viele neue Einsatzmöglichkeiten eröffnet, wie z.B. eine Unterdrückung von Reflexen in einer Fahrbahnkamera in einem Kfz.

Zumeist sind herkömmliche Polfilter passive Elemente, die erst noch mit einem Detektorelement und einer Auswerte-Elektronik versehen werden müssen. Ausführungsbeispiele der vorliegenden Erfindung kombinieren sämtliche Elemente, d.h. Polfilter, Detektorelemente und Auswerte-Elektronik auf einem Chip.

Schließlich soll noch darauf hingewiesen werden, dass obige Ausführungsbeispiele zwar auf die Übereinanderanordnung mehrerer strukturierter Metallschichten 33 abstellten, dass aber auch Alternativbeispiele möglich sind, bei denen lediglich eine strukturierte Metallschicht, wie z.B. 33-1 in Fig. 4, mit den vorerwähnten Nanoöffnungen vorgesehen ist, wie z.B. den mäanderförmigen oder den kreuzförmigen. Allgemeiner ausgedrückt kann die strukturierte Metallschicht eine laterale Verteilung von nicht-konvexen Öffnungen mit einer lateralen Ausdehnung aufweisen, die in zwei zueinander unterschiedlichen lateralen Richtungen unterschiedlich groß ist. So weisen eben die Kreuze in Fig. 9a bei 92 eine größere Ausdehnung in horizontaler Richtung auf als in vertikaler und sind zudem natürlich nicht-konvex, d.h. sie haben eine laterale Form bzw. Ausdehnung, in der es möglich ist, zwei Punkte so zu wählen, dass die Verbindungslinie zwischen diesen Punkten teilweise außerhalb der lateralen Form verläuft. Dabei kann, wie es gezeigt ist, die laterale Verteilung ein regelmäßiges Array mit unterschiedlichen Wiederholabständen in den beiden Richtungen sein, wobei der Wiederholabstand in der Richtung größerer lateraler Ausdehnung größer sein kann. Das Alternativbeispiel nach 92 in Fig. 9a kann aber auch variiert werden, indem die kreuzförmigen Öffnungen als Überkreuzungen von geradlinigen streifenförmigen Öffnungen unterschiedlicher Länge betrachtet werden und diese Öffnungen so gegeneinander versetzt werden, dass eine erste laterale Verteilung von ersten Öffnungen mit einer größten lateralen Ausdehnung in einer ersten Richtung (beispielsweise horizontal) und eine zweite laterale Verteilung von zweiten, von den ersten Öffnungen beabstandeten Öffnungen mit einer größten lateralen Ausdehnung in einer zweiten, zu der ersten unterschiedlichen Richtung (beispielsweise vertikal) entsteht, wofür ein Beispiel in Fig. 9b gezeigt ist. Wieder können dabei die lateralen Verteilungen ein regelmäßiges Array mit unterschiedlichen Wiederholabständen in der ersten und zweiten Richtung sein, wobei der Wiederholabstand in der Richtung größerer lateraler Ausdehnung größer sein kann.

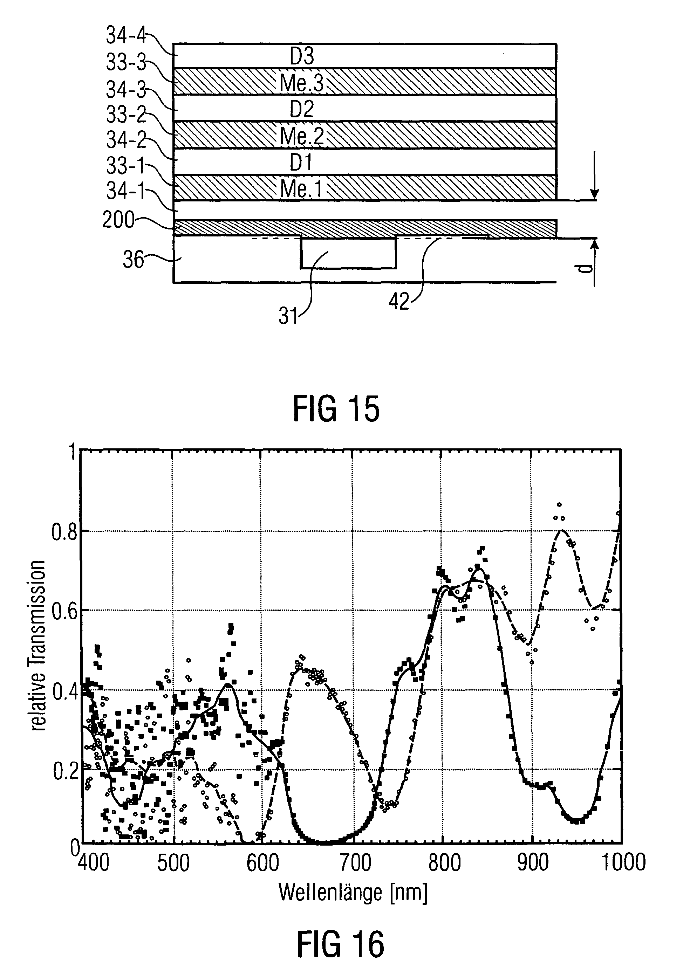

Schließlich sei noch darauf hingewiesen, dass es nicht unbedingt notwendig ist, dass Metallschichten zur Definition der Polarisationsfilterstruktur verwendet werden. Vielmehr kann statt einer strukturierten Metallschicht auch eine strukturierte Polysiliziumschicht verwendet werden. Die Fig. 15 zeigt wie Fig. 4 ein Alternativbeispiel eines in CMOS-Technik hergestellten Polarisationssensors. Wie es zu sehen ist, existieren nach dieser CMOS-Technik die gleichen Schichten wie in Fig. 4. Allerdings ist zwischen der untersten Metallschicht 33-1 und dem Halbleitersubstrat 36 eine Polysiliziumschicht 200 angeordnet. Gemäß einem Alternativbeispiel der vorliegenden Beschreihung ist es nun auch möglich, ein Polarisationselement durch Kombination des opto-elektronischen Sensors 31 mit einer Polarisationsfilterstruktur zu bilden, die durch Strukturierung der Polysiliziumschicht 200 erhalten wird, ggf. in Kombination mit einer Strukturierung einer oder mehrerer der Metallschichten 33-1 bis 33-3. Gemäß alternativen Beispielen wäre natürlich auch eine Kombination mehrerer Polysiliziumschichten möglich. Wie es zu sehen ist, liegt die Polysiliziumschicht 200 direkt auf dem Substrat 36 auf. Hierzu gibt es natürlich auch Alternativen. Ebenso wie die Metallschichten könnte die Polysiliziumschicht 200 auch weiter von dem Halbleitersubstrat 36 entfernt sein, wenn dies ein jeweiliger CMOS-Prozess zulässt. Ferner wäre statt der Verwendung von Polysilizium auch die Verwendung von anderem polykristallinen Halbleitermaterial möglich. Die Strukturierung der Schicht 200, um eine Polarisationsfilterwirkung zu erhalten, kann auf die gleiche Art und Weise bzw. mit den gleichen Abmessungen und Formen vorgenommen werden, wie es im Vorhergehenden Bezug nehmend auf die Metallschichten beschrieben worden ist. Fig. 16 zeigt beispielsweise eine Simulation, die mit einem Gitter erhalten worden ist, das in die Schicht 200 strukturiert worden ist. Dabei zeigt die erhaltene Transmissionsspektrumkurve mit den kreisförmigen Messpunkten eine Transmission bei TEpolarisiertem einfallendem Licht, wohingegen die Messkurve mit den Quadraten eine Transmission bei einfallender TM-Polarisation zeigt.

Schließlich wird bezüglich obiger Ausführungsbeispiele nach darauf hingewiesen, dass bei den hintereinander angeordneten strukturierten Metallschichten zwei oder mehr benachbarte Schichten auch lateral gleich strukturiert sein können. Außerdem können die oben beschriebenen CMOS-Metallschichten, wie z.B. die CMOS-Metalll-Schicht, teilweise neben den Öffnungen zur Bildung der Polarisationsstrukturen elektrische Verbindungen bzw. Leiterbahnen aufweisen, die elektrischen Verbindungen zwischen Schaltungselementen (z.B. Transistoren) des integrierten Polarisationssensors herstellen. Das gilt auch für die soeben gezeigte Polysiliziumschicht. Auch die kann zur Bildung von Leiterbahnen oder Bauelementen lateral beabstandet von dem eigentlichen Polarisationssensor verwendet werden.

Abschließend ist darauf hinzuweisen, dass die vorliegende Erfindung nicht auf die jeweiligen beschriebenen Bauteile oder die erläuterte Vorgehensweise beschränkt ist, da diese Bauteile und Verfahren variieren können. Die hier verwendeten Begriffe sind lediglich dafür bestimmt, besondere Ausführungsformen zu beschreiben und werden nicht einschränkend verwendet. Wenn in der Beschreibung und den Ansprüchen die Einzahl oder unbestimmte Artikel verwendet werden, beziehen sich diese auch auf die Mehrzahl dieser Elemente, solange nicht der Gesamtzusammenhang eindeutig etwas anderes deutlich macht. Dasselbe gilt in umgekehrter Richtung.

Obige Alternativbeispiele beschrieben also auch einen integrierten Polarisationssensor mit einem Polarisationssensorelement 30, wobei das Polarisationssensorelement einen opto-elektronischen Sensor 31 und eine Polarisationsfilterstruktur 32 mit wenigstens einer strukturierten Schicht 33 aus Metall oder polykristallinem Halbleitermaterial aufweist, wobei die wenigstens eine strukturierte Schicht 33 ansprechend auf elektromagnetische Strahlung 12 mit einer vorbestimmten Polarisation eine höhere Transmission durch die Polarisationsfilterstruktur 32 zu dem opto-elektronischen Sensor 31 ergibt als für von der vorbestimmten Polarisation abweichende Polarisationen, wobei der opto-elektronische Sensor 31 und die Polarisationsfilterstruktur 32 gemeinsam auf einem Halbleitersubstrat 36 integriert sind, und wobei die wenigstens eine strukturierte Schicht entweder eine erste laterale Verteilung von ersten Öffnungen mit einer größten lateralen Ausdehnung in einer ersten Richtung und eine zweite laterale Verteilung von zweiten, von den ersten Öffnungen beabstandeten Öffnungen mit einer größten lateralen Ausdehnung in einer zweiten, zu der ersten unterschiedlichen Richtung aufweist, wobei die erste und die zweite Verteilung einen ersten gleichen Wiederholabstand in der ersten Richtung und einen zweiten gleichen Wiederholabstand in der zweiten Richtung aufweisen und zueinander versetzt sind, und zwar um weniger als den ersten Widerholabstand in der ersten Richtung und/oder um weniger als den zweiten Widerholabstand in der zweiten Richtung, um ineinander verschachtelt zu sein, oder eine laterale Verteilung von nicht-konvexen Öffnungen mit einer lateralen Ausdehnung aufweist, die in zwei zueinander unterschiedlichen lateralen Richtungen unterschiedlich groß ist, wobei die nicht-konvexen Öffnungen kreuzförmig sind, aufweist.

Die laterale Verteilung bzw. die erste und die zweite lineare laterale Verteilung kann/können ein regelmäßiges Array mit unterschiedlichen Wiederholabständen in der ersten und zweiten Richtung bzw. in den zueinander unterschiedlichen Richtungen sein. Die laterale Ausdehnung in der ersten Richtung kann senkrecht zu der lateralen Ausdehnung in der zweiten Richtung sein. Die Abmessungen und Abstände der ersten und zweite Öffnungen bzw. nicht-konvexen Öffnungen können kleiner einer Wellenlänge der elektromagnetischen Strahlung sein, bei der die Polaristaionsfilterstruktur höchste Transmission bei der vorbestimmten Polarisation zeigt. Die ersten und zweite Öffnungen bzw. nicht-konvexen Öffnungen können jeweils eine Struktur aufweisen, die gegenüber 90°- und 270°-Drehungen nicht invariant ist. Das Polarisationssensorelement kann eines aus einer Mehrzahl von Polarisationselementen sein, die der integrierte Polarisationssensor aufweist, wobei jeder der Mahrzahl von Polarisationssensoren einen eigenen opto-elektronischen Sensor (31) und eine eigene zugeordnete Polarisationsfilterstruktur (32) aufweist, die durch die strukturierte Schicht (33) aus polykristallinem Halbleitermaterial gebildet wird, indem in derselben lateral an einer Stelle des jeweiligen opto-elektronischen Sensors für jeden opto-elektronischen Sensor eine laterale Verteilung von nicht-konvexen Öffnungen mit einer lateralen Ausdehnung, die in zwei zueinander unterschiedlichen lateralen Richtungen unterschiedlich groß ist, gebildet ist, wobei ein Seitenverhältnis der nicht-konvexen Öffnungen entlang den zwei zueinander unterschiedlichen Richtungen von Polarisationssensorelement zu Polarisationssensorelement unterschiedlich ist. Der Integrierte Polarisationssensor kann ferner ausgebildet sein, um eine Polarisationsrichtung einfallender elektromagnetischer Strahlung auf Basis von Sensorausgangssignalen der opto-elektronischen Sensoren der Mehrzahl von Polarisationssensorelementen zu bestimmen.

## Patentansprüche

1. Integrierter Polarisationssensor zur Detektion zirkular polarisierter elektromagnetischer Strahlung mit zwei nebeneinanderliegenden Polarisationssensorelementen (110; 112), wobei jedes der zwei Polarisationssensorelemente (110; 112)
einen opto-elektronischen Sensor (31); und
eine Polarisationsfilterstruktur (32) mit zwei vertikal übereinander liegenden, strukturierten Metallschichten (33) aufweist, wobei die zwei vertikal übereinander liegenden, strukturierten Metallschichten (33) ansprechend auf elektromagnetische Strahlung (12) mit einer vorbestimmten Polarisation eine höhere Transmission durch die Polarisationsfilterstruktur (32) zu dem opto-elektronischen Sensor (31) ergeben als für von der vorbestimmten Polarisation abweichende Polarisationen, und wobei eine obere der zwei vertikal übereinander liegenden, strukturierten Metallschichten (33) eine Mäanderstruktur aufweist, und bei dem eine untere der zwei vertikal übereinander liegenden, strukturierten Metallschichten (33) eine Gitterlinienstruktur aufweist,
wobei der opto-elektronische Sensor (31) und die Polarisationsfilterstruktur (32) gemeinsam auf einem Halbleitersubstrat (36) integriert sind, und
wobei die Gitterlinienstruktur der unteren der zwei vertikal übereinander liegenden, strukturierten Metallschichten (33) eines ersten Polarisationssensorelements (110; 112) eine zu der Gitterlinienstruktur der unteren der zwei vertikal übereinander liegenden, strukturierten Metallschichten (33) eines zweiten Polarisationssensorelements (112; 110) orthogonale Orientierung aufweist.

2. Integrierter Polarisationssensor gemäß Anspruch 1, bei dem der opto-elektronische Sensor (31) ein PN-Übergangssensor ist.

3. Integrierter Polarisationssensor gemäß Anspruch 1 oder 2, bei dem der opto-elektronische Sensor (31) eine Fotodiode ist.

4. Integrierter Polarisationssensor gemäß einem der vorhergehenden Ansprüche, wobei die elektromagnetische Strahlung (12) Licht ist.

5. Integrierter Polarisationssensor gemäß einem der vorhergehenden Ansprüche, bei dem der opto-elektronische Sensor (31) von einer dem opto-elektronischen Sensor zugewandten Seite der Polarisationsfilterstruktur (32) einen vorbestimmten Abstand (d) aufweist, der kleiner als 20 µm und bevorzugt kleiner als 8 µm ist.

6. Integrierter Polarisationssensor gemäß einem der vorhergehenden Ansprüche, der in CMOS-Technologie gefertigt ist, wobei die strukturierten Schichten Schichten der CMOS-Technologie sind.

7. Integrierter Polarisationssensor gemäß einem der vorhergehenden Ansprüche, der ferner ausgebildet ist, um eine Richtung der zirkular polarisierten elektromagnetischen Strahlung aus einem Winkel einer linear polarisierten elektromagnetischen Strahlung zu bestimmen, die sich nach Durchtritt der zirkular polarisierten elektromagnetischen Strahlung durch die Mäanderstruktur der oberen der zwei vertikal übereinander liegenden, strukturierten Metallschichten (33) ergibt, und den Winkel wiederum aus Messergebnissen der opto-elektrischen Sensoren der zwei Polarisationssensorelemente (110; 112).

8. Verfahren zur Bestimmung einer Richtung zirkular polarisierter elektromagnetischer Strahlung, mit folgenden Schritten:
Anordnen zweier Polarisationsfilterstrukturen (32), die jeweils zwei vertikal übereinander liegende, strukturierte Metallschichten (33) aufweisen, die ansprechend auf elektromagnetische Strahlung (12) mit einer vorbestimmten Polarisation eine höhere Transmission durch die Polarisationsfilterstruktur (32) zu dem opto-elektronischen Sensor (31) ergeben als für von. der vorbestimmten Polarisation abweichende Polarisationen, und von denen eine obere eine Mäanderstruktur und eine untere eine Gitterlinienstruktur aufweist, wobei die Gitterlinienstruktur der unteren der zwei vertikal übereinander liegenden, strukturierten Metallschichten (33) einer ersten der zwei Polarisationsfilterstrukturen eine zu der Gitterlinienstruktur der unteren der zwei vertikal übereinander liegenden, strukturierten Metallschichten (33) eines zweiten der zwei Polarisationsfilterstrukturen orthogonale Orientierung aufweist;;
Empfangen von auf die zwei Polarisationsfilterstrukturen ausgesendeter, und durch die zwei Polarisationsfilterstrukturen (32) polarisierter elektromagnetischer Strahlung (12) mit jeweils einem opto-elektronischen Sensor (31); und
Bestimmen einer Richtung einer Zirkularpolarisation der elektromagnetischen Strahlung aus einem Winkel einer linear polarisierten elektromagnetischen Strahlung, die sich nach Durchtritt der elektromagnetischen Strahlung durch die Mäanderstruktur der oberen der zwei vertikal übereinander liegenden, strukturierten Metallschichten (33) in den zwei Polarisationsfilterstrukturen ergibt, und des Winkels wiederum aus den durch die opto-elektrischen Sensoren der zwei Polarisationssensorelemente (110; 112) empfangenen elektromagnetischen Strahlungen.

## Claims

1. Integrated polarization sensor for detecting circularly polarized electromagnetic radiation with two adjacent polarization sensor elements (110; 112), each of the two polarization sensor elements (110; 112) comprising:
an optoelectronic sensor (31); and
a polarization filter structure (32) comprising two vertically superimposed structured metal layers (33), wherein the two vertically superimposed structured metal layers (33) result, in response to electromagnetic radiation (12) having a predetermined polarization, in a higher transmission through the polarization filter structure (32) to the optoelectronic sensor (31) than for polarizations deviating from the predetermined polarization, and wherein an upper one of the two vertically superimposed structured metal layers (33) comprises a meander structure, and wherein a lower one of the two vertically superimposed structured metal layers (33) comprises a grid line structure,
wherein the optoelectronic sensor (31) and the polarization filter structure (32) are integrated together on a semiconductor substrate (36);
wherein the grid line structure of the lower on of the two vertically superimposed structured metal layers (33) of a first polarization sensor element (110; 112) has an orientation orthogonal to the grid line structure of the lower one of the two vertically superimposed structured metal layers (33) of a second polarization sensor element (112; 110).

2. Integrated polarization sensor according to claim 1, wherein the optoelectronic sensor (31) is a PN junction sensor.

3. Integrated polarization sensor according to claims 1 or 2, wherein the optoelectronic sensor (31) is a photodiode.

4. Integrated polarization sensor according to one of the previous claims, wherein the electromagnetic radiation (12) is light.

5. Integrated polarization sensor according to one of the previous claims, wherein the optoelectronic sensor (31) comprises a predetermined distance (d) to a side of the polarization filter structure (32) facing the optoelectronic sensor, which is smaller than 20 µm and preferably smaller than 8 µm.

6. Integrated polarization sensor according to one of the previous claims, which is produced in CMOS technology, wherein the structured layers are layers of the CMOS technology.

7. Integrated polarization sensor according to one of the previous claims, which is further implemented to determine a direction of the circularly polarized electromagnetic radiation from an angle of a linearly polarized electromagnetic radiation, which results after a passage of the circularly polarized electromagnetic radiation through the meander structure of the upper one of the two vertically superimposed structured metal layers (33), and the angle, on the other hand, from the measurement results of the optoelectronic sensors of the two polarization sensor elements (110; 112).

8. Method for determining a direction of a circularly polarized electromagnetic radiation, comprising:
arranging two polarization filter structures (32), each comprising two vertically superimposed structured metal layers (33), which result, in response to electromagnetic radiation (12) having a predetermined polarization, in a higher transmission through the polarization filter structure (32) to the optoelectronic sensor (31), than for polarizations deviating from the predetermined polarization, and of which an upper one comprises a meander structure and a lower one a grid line structure, wherein the grid line structure of the lower one of the two vertically superimposed structured metal layers (33) comprises an orientation which is orthogonal to the grid line structure of the lower of the two vertically superimposed structured metal layers (33) of a second one of the two polarization filter structures:
receiving, by one optoelectronic sensor (31) each, polarized electromagnetic radiation (12) transmitted to the two polarization filter structures and polarized by the two polarization filter structures (32); and
determining a direction of a circular polarization of the electromagnetic radiation from an angle of a linearly polarized electromagnetic radiation, which results after a passage of the electromagnetic radiation through the meander structure of the upper one of the two vertically superimposed structured metal layers (33) in the two polarization filter structures, and the angle, on the other hand, from the electromagnetic radiations received by the optoelectronic sensors of the two polarization sensor elements (110; 112).

## Revendications

1. Capteur de polarisation intégré pour détecter un rayonnement électromagnétique polarisé circulaire avec deux éléments capteurs de polarisation adjacents (110; 112), chacun des deux éléments capteurs de polarisation (110; 112) présentant
un capteur optoélectronique (31); et
une structure de filtre de polarisation (32) avec deux couches métalliques structurées (33) situées verticalement l'une au-dessus de l'autre, les deux couches métalliques structurées (33) situées verticalement l'une au-dessus de l'autre donnant, en réponse au rayonnement électromagnétique (12) à polarisation prédéterminée, une plus grande transmission par la structure de filtre de polarisation (32) vers le capteur optoélectronique (31) que pour les polarisations s'écartant de la polarisation prédéterminée, et une supérieure des deux couches métalliques structurées (33) situées verticalement l'une au-dessus de l'autre (32) présentant une structure en méandre, et où une inférieure des deux couches métalliques structurées (33) situées verticalement l'une au-dessus de l'autre (33) présente une structure à lignes de grille,
dans lequel le capteur optoélectronique (31) et la structure de filtre de polarisation (32) sont intégrés en commun sur un substrat semi-conducteur (36), et
dans lequel la structure à lignes de grille de l'inférieure des deux couches métalliques structurées (33) situées verticalement l'une au-dessus de l'autre d'un premier élément capteur de polarisation (110; 112) présente une orientation orthogonale à la structure à lignes de grille de l'inférieure des deux couches métalliques structurées (33) situées verticalement l'une au-dessus de l'autre d'un deuxième élément capteur de polarisation (112; 110).

2. Capteur de polarisation intégré selon la revendication 1, dans lequel le capteur optoélectronique (31) est un capteur de transition PN.

3. Capteur de polarisation intégré selon la revendication 1 ou 2, dans lequel le capteur optoélectronique (31) est une photodiode.

4. Capteur de polarisation intégré selon l'une des revendications précédentes, dans lequel le rayonnement électromagnétique (12) est de la lumière.

5. Capteur de polarisation intégré selon l'une des revendications précédentes, dans lequel le capteur optoélectronique (31) d'un côté de la structure de filtre de polarisation (32) faisant face au capteur optoélectronique présente une distance prédéterminée (d) qui est inférieure à 20 µm et, de préférence, inférieure à 8 µm.

6. Capteur de polarisation intégré selon l'une des revendications précédentes, qui est réalisé en technologie CMOS, dans lequel les couches structurées sont des couches de la technologie CMOS.

7. Capteur de polarisation intégré selon l'une des revendications précédentes, qui est par ailleurs réalisé pour déterminer une direction du rayonnement électromagnétique polarisé circulaire à partir d'un angle d'un rayonnement électromagnétique polarisé linéaire qui résulte après le passage du rayonnement électromagnétique polarisé circulaire à travers la structure en méandre de la supérieure des deux couches métalliques structurées (33) situées verticalement l'une au-dessus de l'autre, et l'angle, quant à lui, à partir des résultats de mesure des capteurs optoélectroniques des deux éléments capteurs de polarisation (110; 112).

8. Procédé pour déterminer une direction d'un rayonnement électromagnétique polarisé circulaire, aux étapes suivantes consistant à:
disposer deux structures de filtre de polarisation (32) présentant, chacune, deux couches métalliques structurées (33) situées verticalement l'une au-dessus de l'autre qui donnent, en réponse à un rayonnement électromagnétique (12) à polarisation prédéterminée, une plus grande transmission à travers la structure de filtre de polarisation (32) vers le capteur optoélectronique (31) que pour des polarisations s'écartant de la polarisation prédéterminée, et dont une supérieure présente une structure en méandre et une inférieure présente une structure à lignes de grille, la structure à lignes de grille de l'inférieure des deux couches métalliques structurées (33) situées verticalement l'une au-dessus de l'autre d'une première des deux structures de filtre de polarisation présente une orientation orthogonale à la structure à lignes de grille de l'inférieure des deux couches métalliques structurées (33) situées verticalement l'une au-dessus de l'autre d'une deuxième des deux structures de filtre de polarisation;
recevoir du rayonnement électromagnétique (12) émis vers les deux structures de filtre de polarisation et polarisé par les deux structures de filtre de polarisation (32) par respectivement un capteur optoélectronique (31); et
déterminer une direction d'une polarisation circulaire du rayonnement électromagnétique à partir d'un angle d'un rayonnement électromagnétique polarisé linéaire qui est obtenu après le passage du rayonnement électromagnétique à travers la structure en méandre de la supérieure des deux couches métalliques structurées (33) situées verticalement l'une au-dessus de l'autre et de l'angle, à son tour, à partir des rayonnements électromagnétiques reçus par les capteurs optoélectroniques des deux éléments capteurs de polarisation (110; 112).
